# EUROPEAN PATENT APPLICATION

(11) **EP 1 239 519 A2**
(43) Date of publication of application: **11.09.2002**
(21) Application number: 02004859.1
(22) Date of filing: 04.03.2002
(51) Int. Cl.: H01L 25/16, H01L 31/0203, H01L 31/0232, H01L 27/146

(54) **Image pickup model and image pickup device**

(30) Priority: 05.03.2001 JP 2001060188; 29.05.2001 JP 2001160816; 29.10.2001 JP 2001331123
(71) Applicant: CANON KABUSHIKI KAISHA, Ohta-ku, Tokyo (JP)
(72) Inventor: Suda, Yasuo, Tokyo (JP); Yamasaki, Ryo, Tokyo (JP)
(74) Representative: Leson, Thomas Johannes Alois, Dipl.-Ing.

(57) **Abstract**

The invention provides an image pickup module comprising a semiconductor chip including a photosensor array, and an optical element for guiding light to the photosensor array, wherein the optical element includes a imaging unit and a light shielding layer, and adhesive is formed in a position between the semiconductor chip and the optical element but excluding the position of the light shielding layer in the incident direction of light, and the optical element and the semiconductor chip are fixed across the adhesive. The invention also provides an image pickup module comprising an optical element provided on a semiconductor chip, wherein the optical element includes a first lens and a second lens which is provided corresponding to the first lens.

## Description

### BACKGROUND OF THE INVENTION

### Field of the Invention

The present invention relates to an image pickup module and an image pickup device, and more particularly to a structure of the image pickup module in which an imaging optical system and a semiconductor chip are integrated.

### Related Background Art

In a conventional compact image pickup module, an imaging lens and a semiconductor chip have been integrated.

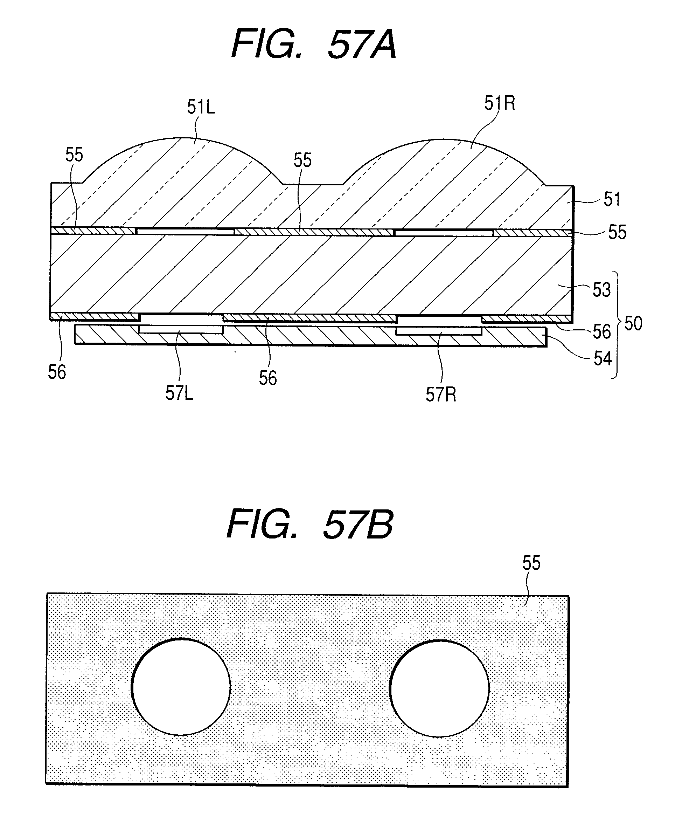

Figs. 57A and 57B show, as an example of the compact image pickup module, a configuration similar to a distance measuring module disclosed in the Japanese Patent Application Laid-open No. 09-027606. Figs. 57A and 57B show a lens member 51 and a COG (chip on glass) configuration 50 in which a semiconductor chip 54 is mounted on the lower face of a glass substrate 53. The lens member 51 is molded with plastics or glass, and is provided with lenses 51L, 51R for forming two images for measuring the distance to the object by the trigonometric principle. Also the semiconductor chip 54 is provided with photosensor portions 57L, 57R consisting of one-dimensional array of photosensor elements, and the object lights transmitted by the lenses 51L, 51R are respectively focused on the photosensor units 57L, 57R.

On the upper surface of the glass substrate 53, a light-shielding layer 55 of a pattern shown in Fig. 57B is printed to form a diaphragm, and, on the lower surface of the glass substrate 53, a light shielding/conductive member 56 is formed as connection terminals for the semiconductor chip 54 and as external terminals.

Such COG configuration allows to dispense with the sensor package for example of plastics, and the integral structure with the lens allows to dispense with the lens barrel whereby the manufacturing cost can be maintained relatively low.

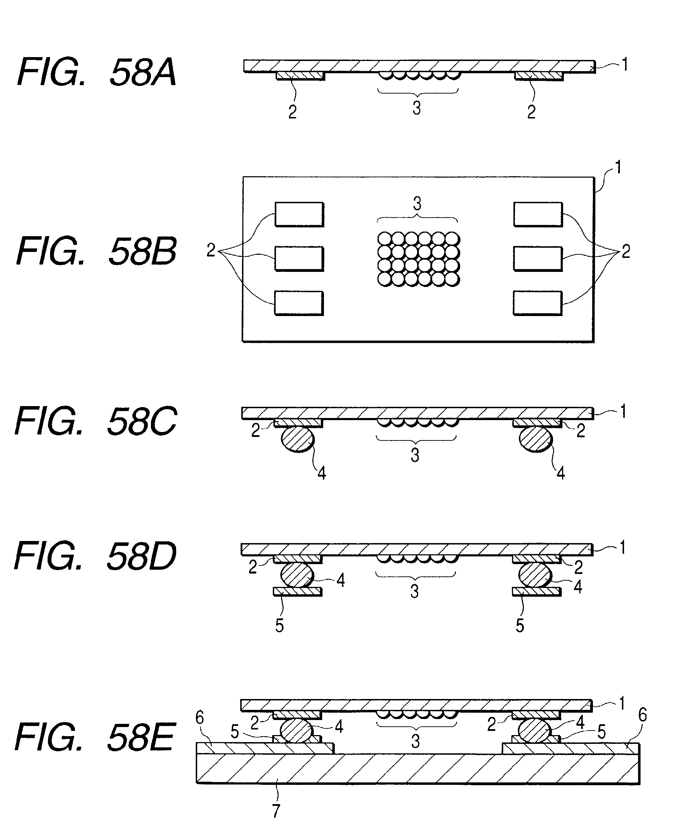

On the other hand, the packaging of the semiconductor chip for example by wire bonding will result in a larger and thicker package and in a higher mounting cost, in comparison with the COG configuration. Therefore, there is proposed a technology of sealing the photosensor unit with thermal/ultraviolet setting resin. Figs. 58A to 58H are schematic cross-sectional views showing the manufacturing steps of an image pickup module (semiconductor device), disclosed in the Japanese Patent Application Laid-open No. 11-121653, wherein Fig. 58A is a cross-sectional view of a semiconductor chip 1, and Fig. 58B is a plan view of the semiconductor chip 1 shown in Fig. 58A, seen from below.

More specifically in the manufacturing process, there is at first prepared a semiconductor chip 1 which is provided with electrode pads (bonding pads) 2 in the vicinity of the external periphery and with a microlens group 3, consisting of closely packed microlenses at the central portion. The electrode pads are composed for example of Al or Cr, and the microlens group 3 is composed for example of a plastic material. The semiconductor chip 1 is for example a solid-state image pickup device including a photoelectric sensor and a CCD. The photoelectric sensor is for example composed of a photodiode for converting the light, received from the exterior through the microlens group 3, into an electrical signal, which is transferred by the CCD to generate an image signal.

For forming the microlens group 3, there is at first formed a plastic film, and a resist film of a predetermined pattern is formed thereon. Then heating is executed to round the corners of the resist film, thereby forming the microlenses. The semiconductor chip is prepared by an already known method. In order to achieve the light-condensing function of the microlens group 3, it is necessary, in mounting the semiconductor chip on the glass substrate, to form a hollow portion between the glass substrate and the photosensensor element of the semiconductor chip.

In the following there will be explained the connection of the semiconductor chip 1 and the glass substrate, in an example of employing gold ball and conductive resin. As shown in Fig. 58C, a gold ball 4, for example of a size of 30 to 80 µm, is placed by a ball bonding apparatus on the electrode pad 2 of the semiconductor chip 1.

Then, as shown in Fig. 58D, conductive resin 5 is attached to the lower part of the gold ball 4. The conductive resin 5 can be attached to the gold ball 4 for example by employing a palette of which surface is entirely coated with the conductive resin 5. The conductive resin 5 is for example composed of silver particles dispersed in epoxy resin (silver paste).

Then, as shown in Fig. 58E, an electrode 6 of a transparent substrate (for example glass substrate) 7 is brought into contact with the corresponding electrode pad 2 of the semiconductor chip 1 across the gold ball 4, and heating is executed to set the conductive resin 5, whereby the electrode 6 of the transparent substrate 7 and the electrode pad 2 of the semiconductor chip 1 are electrically connected in a predetermined route. The heating is executed for example under conditions of 100°C to 200°C for 30 minutes. The electrode 6 is composed for example of Cr or Ni, and is formed on the transparent substrate 7 by evaporation, plating or sputtering and is patterned by photolithography or etching.

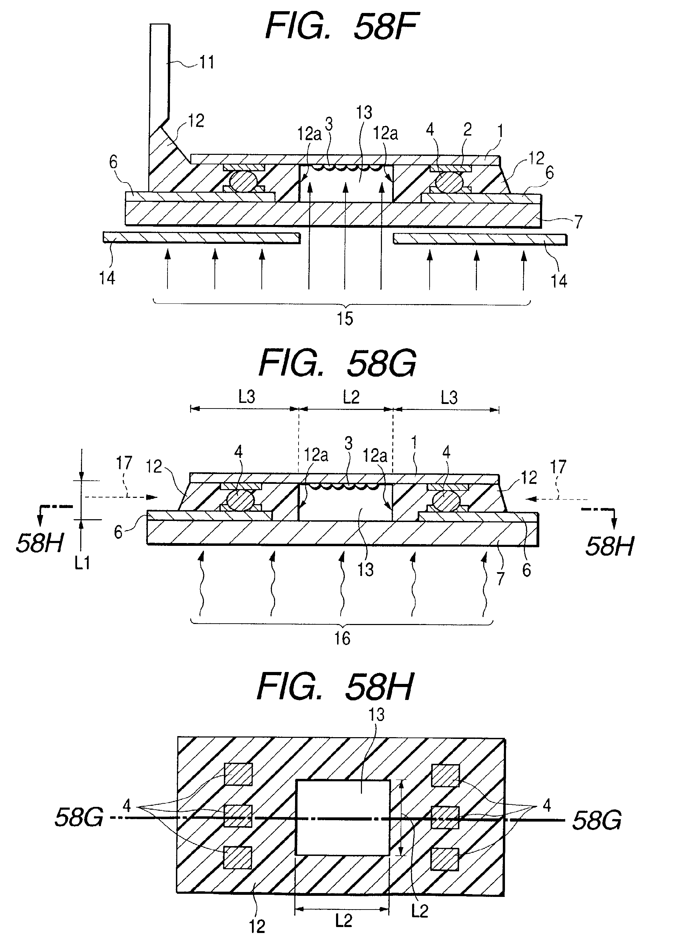

The transparent substrate 7 is composed of a transparent insulating material such as glass, polycarbonate, polyester or capton, preferably glass. In the following there will be explained an example employing a transparent substrate 7 composed of glass. As shown in Fig. 58F, a light shielding mask 14 is positioned opposed to the lower face of the glass substrate 7, and is irradiated with electromagnetic wave (for example ultraviolet light) 15 from below the glass substrate 7. The light shielding mask 14 is provided with such a predetermined pattern as to transmit the electromagnetic wave 15 only in a region 13 including the microlens group 3. The electromagnetic wave 15 is for example ultraviolet light, infrared light, visible light or X-ray, and preferably ultraviolet light. In the following there will be explained a case of employing ultraviolet light as the electromagnetic wave 15. Under the irradiation with the ultraviolet light 15, insulating thermal-ultraviolet settable resin 12 is supplied from a capillary 11 into the gap between the semiconductor chip 1 and the glass substrate 7 for example at normal temperature.

The thermal-ultraviolet settable resin 12 enters the gap between the semiconductor chip 1 and the glass substrate 7 from the end portion thereof toward the center thereof by the capillary phenomenon.

The thermal-ultraviolet settable resin 12 can be set or hardened by ultraviolet light or by heat. It flows in a region not subjected to the irradiation with the ultraviolet light 15 and is set in a region subjected to the irradiation with the ultraviolet light 15. As a result, the thermal-ultraviolet settable resin 12 is hardened at the boundary between the region 13 irradiated with the ultraviolet light and the region not subjected to the irradiation with the ultraviolet light.

Once the thermal-ultraviolet settable resin 12 is hardened at such boundary, it no longer flows into the ultraviolet light irradiated region 13. In practice, however, since the thermal-ultraviolet settable resin 12 requires certain time for hardening, it is hardened after somewhat flowing into the ultraviolet light irradiated region 13.

The electrode pad 2 of the semiconductor chip 1 and the electrode 6 of the glass substrate 7 are connected across the gold ball 4, and the thermal-ultraviolet settable resin 12 covers the electrode pad 2 and the gold ball 4 entirely and a part of the electrode 6.

The supply of the thermal-ultraviolet settable resin 12 from the capillary 11 is terminated when it is sufficiently introduced into the gap between the semiconductor chip 1 and the glass substrate 7.

The ultraviolet light irradiated region 13 shown in Fig. 58F is a rectangular region, when seen from above as shown in Fig. 58H. However, the central portion of the rectangular region need not be irradiated with the ultraviolet light. In this manner a hollow portion 13 is formed between the portion of the microlens group 3 of the semiconductor chip 1 and the glass substrate 7, and the thermal-ultraviolet settable resin 12 is so formed as to surround such hollow portion 13.

In such state, however, only the thermal-ultraviolet settable resin 12a present in the boundary portion is hardened and the thermal-ultraviolet settable resin 12 is not hardened in a portion not subjected to the irradiation with the ultraviolet light 15.

Then, as shown in Fig. 58G, heat 16 is applied in order to harden the thermal-ultraviolet settable resin 12 in the portion not irradiated with the ultraviolet light 15. The heating is executed for example for 5 hours at 80°C. Thus the thermal-ultraviolet settable resin 12 is completely hardened by heating, in the entire area between the semiconductor chip 1 and the glass substrate 7. The ultraviolet hardening shown in Fig. 58F may be called pre-hardening while the thermal hardening shown in Fig. 58G may be called main hardening. The COG configuration is completed through the above-described process.

Fig. 58G is a schematic cross-sectional view along a line 58G-58G in Fig. 58H, and the thermal-ultraviolet settable resin 12 is so formed as to surround the hollow portion 13. The gold ball 4 connects the electrode pad 2 of the semiconductor chip 1 and the electrode 6 of the glass substrate 7 electrically and mechanically. However, since the mechanical connection by the gold ball 4 is weak, it is reinforced by the thermal-ultraviolet settable resin 12 present between the semiconductor chip 1 and the glass substrate 7. The thermal-ultraviolet settable resin 12, being electrically insulating, does not alter the electrical connection between the semiconductor chip 1 and the glass substrate 7.

Through the above-described process, the photosensor unit including the microlenses is sealed by the transparent substrate and the thermal-ultraviolet settable resin, thereby being protected from dust intrusion or deterioration by the humidity in the air. The microlens is generally provided with a surface convex to the incident direction of light to condense the incident light onto the photosensor smaller than the microlens by the light diffraction at the air-resin or air-glass interface, thereby improving the light receiving efficiency of the photosensor.

The aforementioned patent application also discloses a method of mass producing the above-described image pickup module.

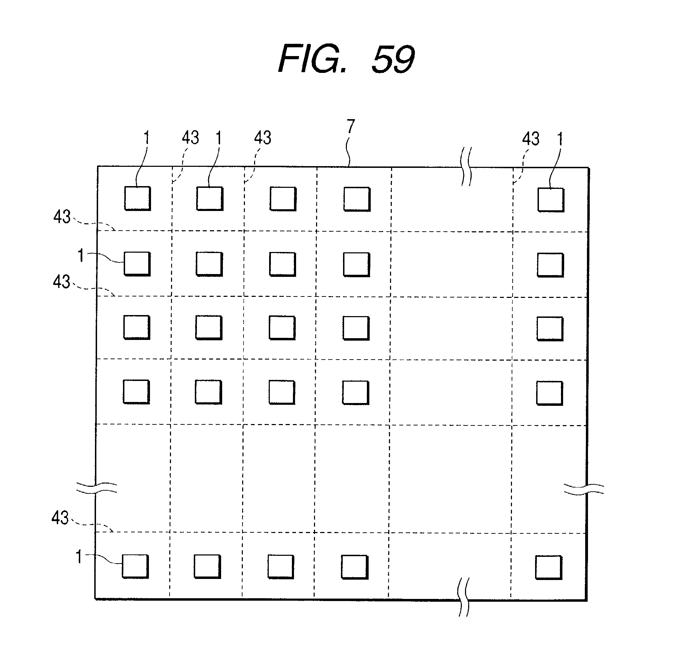

Fig. 59 is a plan view of the transparent substrate (for example glass substrate) 7. The glass substrate 7 has, for example, a length of 150 mm, a width of 150 mm and a thickness of 1 mm, and is divided into 10 × 10 blocks, each having a length of 15 mm, a width of 15 mm and a thickness of 1 mm.

100 semiconductor chips 1 in total are mounted on the glass substrate 7 by mounting a semiconductor chip 1 in each block. Each semiconductor chip 1 has, for example, a length of 8 mm and a width of 6 mm.

Then resin is introduced between the semiconductor chips 1 and the glass substrate 7, and is pre-hardened for example with ultraviolet light. Then the glass substrate 7 is placed in an oven of 150°C for 30 minutes to harden the resin, thereby fixing the semiconductor chips 1 to the glass substrate 7. Then the glass substrate 7 is cut by a cutter along block boundary lines 43, thereby separating each image pickup module. In this manner there are completed 100 image pickup modules.

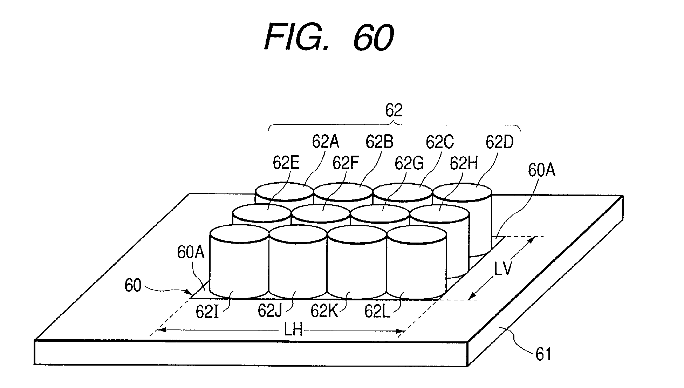

Fig. 60 is a perspective view of a conventional image pickup module employing a distributed refractive index lenses.

A photosensor unit 60 is formed on a semiconductor chip 61 composed for example of a silicon substrate. Plural lens units 62 are provided in an array on a same plane, and are composed of distributed refractive index lenses 62A to 62L. They are provided on an image pickup plane 60A of the photosensor unit 60 in such a manner that they are in contact at the exit end faces thereof with the image pickup plane 60A, whereby the light transmitted by the plural lens units 60 is supplied to the image pickup plane 60A. The distributed refractive index lenses 62A to 62L have respectively different distribution of the refractive index to have different focal lengths or different focal positions, whereby image data corresponding to plural focal positions of the objects can be simultaneously generated.

Such configuration, as in the case of the COG configuration, allows to dispense with the sensor package such as of plastics and the integrated lens structure allows to dispense with the lens barrel, whereby the manufacturing cost can be maintained relatively low.

However, the manufacture of the lens-integrated image pickup module according to the above-described conventional technologies has been associated with the following drawbacks.

### (Technical drawback 1)

The configuration shown in Figs. 57A, 57B and 60 allows to obtain an image pickup module without requiring the sensor package, but, since the photosensor unit is not sealed, it is difficult to prevent dust intrusion or deterioration or the microlenses or the filter layer by the humidity in the air. Besides, the sealing technology utilizing the thermal-ultraviolet settable resin, explained in Figs. 58A to 58H, is not applicable in the configuration shown in Figs. 57A and 57B, since a light shielding layer 55 covers the entire surface of the semiconductor chip and intercepts the light from the front side thereof.

Also the step of coupling the imaging lenses and the semiconductor chip necessitates active assembly thereof, involving many adjusting steps.

Furthermore, even if the plural imaging lenses are integrated on the glass substrate 7 shown in Fig. 59, there is still required precise alignment of the imaging lenses with the corresponding semiconductor chip, so that many adjusting steps are still unavoidable.

Also an ITO film has to be formed on the glass substrate for connection with the external electrical circuit, resulting in a disadvantage in cost.

In consideration of such technical drawback 1, an object of the present invention is to provide an image pickup module of integrated imaging lens type, enabling easy sealing of the photosensor unit.

Another object of the present invention is to simplify the alignment step of the imaging lens and the semiconductor chip, thereby providing an inexpensive high-performance image pickup module of integrated imaging lens type.

### (Technical drawback 2)

The image pickup module shown in Fig. 57A is deficient in the optical performance for use as an image pickup optical system, since the imaging lens is composed solely of a single lens 51. Though it is conceivable to increase the number of lenses or of faces having lens function, but such increase will increase the dimension of the image pickup optical system. Also a similar drawback is encountered in case the image pickup optical system is composed of distributed refractive index lenses.

In consideration of such technical drawback 2, an object of the present invention is to provide an image pickup module of integrated lens type with improved image pickup performance and an image pickup device provided with such image pickup module.

### SUMMARY OF THE INVENTION

The aforementioned technical drawback 1 can be resolved, according to the present invention, by an image pickup module comprising a semiconductor chip including a photosensor array and an optical element for guiding light to the photosensor array, wherein the optical element includes a imaging unit and a light shielding layer, and an adhesive is formed in a position between the semiconductor chip and the optical element but outside the light shielding layer in the incident direction of the light, and the optical element and the semiconductor chip are fixed through the adhesive.

Also the aforementioned technical drawback 2 can be resolved, according to the present invention, by an image pickup module comprising an optical element provided on a semiconductor chip, wherein the optical element includes a first lens and a second lens and the second lens is provided corresponding to the second lens.

According to the present invention, there is also provided an image pickup module comprising a semiconductor chip including a photosensor array and an optical element for guiding light to the photosensor array, wherein the optical element includes a light shielding layer, a first lens and a second lens corresponding to the first lens, and adhesive is formed between the semiconductor chip and the optical element but outside the light shielding layer in the incident direction of the light, and the optical element and the semiconductor chip are fixed through the adhesive.

### BRIEF DESCRIPTION OF THE DRAWINGS

Fig. 1A is a schematic cross-sectional view showing the configuration of an image pickup module constituting an embodiment 1 of the present invention;
Fig. 1B is a schematic cross-sectional view showing another configuration of the image pickup module of the present invention;
Fig. 2A is a plan view of an upper substrate constituting the optical element of the image pickup module of the embodiment 1 of the present invention;
Fig. 2B is a plan view of a lower substrate constituting the optical element of the image pickup module of the embodiment 1 of the present invention;
Fig. 2C is a plan view of a semiconductor chip of the image pickup module of the embodiment 1 of the present invention;
Fig. 3 is a schematic cross-sectional view of the semiconductor chip along a line 3-3 in Fig. 2C;
Fig. 4 is a schematic cross-sectional view showing the light incident direction to the image pickup module of the embodiment 1 of the present invention;
Fig. 5 is a plan view of an upper substrate assembly in a manufacturing process for the image pickup module of the embodiment 1 of the present invention;
Fig. 6 is a plan view of a lower substrate assembly in the manufacturing process for the image pickup module of the embodiment 1 of the present invention;
Fig. 7 is a plan view of a semiconductor wafer in the manufacturing process for the image pickup module of the embodiment 1 of the present invention;
Fig. 8 is a schematic cross-sectional view of an adhesive hardening step in the manufacturing process for the image pickup module of the embodiment 1 of the present invention;
Fig. 9A is a plan view showing a step of separating an image pickup module from an optical element-semiconductor wafer adjoined member in the manufacturing process for the image pickup module of the embodiment 1 of the present invention;
Fig. 9B is a schematic cross-sectional view along a line 9B-9B in Fig. 9A;
Fig. 10 is a plan view showing two convex lenses formed on the upper substrate assembly;
Fig. 11 is a schematic cross-sectional view showing a dicing step for the optical element-semiconductor wafer adjoined member in the manufacturing process for the image pickup module of the embodiment 1 of the present invention;
Fig. 12 is a schematic cross-sectional view of an image pickup module in an embodiment 2 of the present invention;
Fig. 13A is a plan view of a lower substrate constituting the optical element of the image pickup module of the embodiment 2 of the present invention;
Fig. 13B is a plan view of a semiconductor chip of the image pickup module of the embodiment 2 of the present invention;
Fig. 14 is a plan view of the semiconductor wafer in a step of adjoining the optical element assembly and the semiconductor wafer in the manufacturing process for the image pickup module of the embodiment 2 of the present invention;
Fig. 15A is a plan view showing a lower substrate in an image pickup module of an embodiment 3 of the present invention;
Fig. 15B is a plan view showing a semiconductor chip in the image pickup module of the embodiment 3 of the present invention;
Fig. 16 is a plan view of a lower substrate assembly in a manufacturing process for the image pickup module of the embodiment 3 of the present invention;
Fig. 17 is a plan view of a semiconductor wafer in the manufacturing process for the image pickup module of the embodiment 3 of the present invention;
Fig. 18 is a plan view of an upper substrate assembly in the manufacturing process for the image pickup module of the embodiment 3 of the present invention;
Fig. 19 is a schematic cross-sectional view along a line 19-19 in Fig. 18;
Fig. 20 is a schematic cross-sectional view showing a dicing step for the optical element-semiconductor wafer adjoined member in the manufacturing process for the image pickup module of the embodiment 3 of the present invention;
Fig. 21 is a plan view of the image pickup module of the embodiment 3 of the present invention;
Fig. 22 is a schematic cross-sectional view along a line 22-22 in Fig. 21;
Fig. 23 is a schematic cross-sectional view showing sealed state and connection state of the image pickup module of the embodiment 3 of the present invention with an external electrical circuit;
Fig. 24 is a schematic cross-sectional view showing a step of ultraviolet irradiation to the optical element-semiconductor wafer adjoined member in the manufacturing process for the image pickup module of an embodiment 4 of the present invention;
Fig. 25 is a schematic cross-sectional view of the image pickup module of the embodiment 4 of the present invention;
Fig. 26A is a plan view of an image pickup module of an embodiment 5 of the present invention;
Fig. 26B is a schematic cross-sectional view along a line 26B-26B in Fig. 26A;
Fig. 26C is a plan view of a semiconductor chip constituting the image pickup module of the embodiment 5 of the present invention;
Fig. 27 is a magnified schematic cross-sectional view of a region Z in Fig. 26C;
Fig. 28 is a view showing the positional relationship between the object images of stereoscopic lenses provided in the image pickup module of the embodiment 5 of the present invention and image pickup areas;
Fig. 29 is a view showing the positional relationship of the pixels when the image pickup areas shown in Fig. 28 are projected;
Fig. 30 is a plan view showing a spacer assembly mounted in the image pickup module of the embodiment 5 of the present invention;
Fig. 31 is a plan view of a semiconductor wafer in the manufacturing process for the image pickup module of the embodiment 5 of the present invention;
Fig. 32 is a plan view showing a step of adhering the spacer assembly to the semiconductor wafer in the manufacturing process for the image pickup module of the embodiment 5 of the present invention;
Fig. 33 is a chart showing the spectral transmission characteristics of an infrared cut-off filter;
Fig. 34 is a plan view showing a step of adhering the stereoscopic optical element assembly and the semiconductor wafer, prior to the separation of the stereoscopic optical element for each image pickup module, in the manufacturing process for the image pickup module of the embodiment 5 of the present invention;
Fig. 35 is a schematic cross-sectional view showing a dicing step for the semiconductor wafer with a dicing blade in the manufacturing process for the image pickup module of the embodiment 5 of the present invention;
Fig. 36 is a schematic cross-sectional view showing sealed state and connection state of the image pickup module of the embodiment 5 of the present invention with an external electrical circuit;
Fig. 37 is a schematic cross-sectional view an image pickup module of an embodiment 6 of the present invention;
Fig. 38 is a schematic cross-sectional view showing a step of ultraviolet irradiation to the optical element-semiconductor wafer adjoined member in a manufacturing process for the image pickup module of the embodiment 6 of the present invention;
Fig. 39 is a plan view of an optical element assembly constituting the image pickup module of the embodiment 6 of the present invention;
Fig. 40A is a plan view of an image pickup module of an embodiment 7 of the present invention;
Fig. 40B is a schematic cross-sectional view along a line 40B-40B in Fig. 40A;
Fig. 41 is a plan view of a lower substrate of the image pickup module of the embodiment 7 of the present invention;
Fig. 42 is a plan view of a semiconductor chip in the image pickup module of the embodiment 7 of the present invention;
Fig. 43 is magnified schematic cross-sectional view of a region z in Fig. 42, showing the function of microlenses in the image pickup module of the embodiment 7 of the present invention;
Fig. 44 is a view showing the positional relationship between the photosensor array of the semiconductor chip and the object image in the image pickup module of the embodiment 7 of the present invention;
Fig. 45 is a view showing the function of the photosensor array of the image pickup module of the embodiment 7 of the present invention;
Fig. 46 is a schematic cross-sectional view showing sealed state and connection state of the image pickup module of the embodiment 7 of the present invention with an external electrical circuit;
Fig. 47 is a schematic cross-sectional view showing another configuration of the image pickup module of the embodiment 7 of the present invention;
Fig. 48 is a plan view of an upper substrate assembly in the manufacturing process for the image pickup module of the embodiment 7 of the present invention;
Fig. 49 is a plan view of a lower substrate assembly in the manufacturing process for the image pickup module of the embodiment 7 of the present invention;
Fig. 50 is a plan view of a semiconductor wafer in the manufacturing process for the image pickup module of the embodiment 7 of the present invention;
Fig. 51 is a schematic cross-sectional view of a step for separating an image pickup module from an optical element-semiconductor wafer adjoined member in the manufacturing process for the image pickup module of the embodiment 7 of the present invention;
Fig. 52 is a plan view of an image pickup module of an embodiment 8 of the present invention;
Fig. 53 is a schematic cross-sectional view of the image pickup module along a line 53-53 in Fig. 52;
Figs. 54A, 54B and 54C are views showing a digital color camera provided with the image pickup module of the present invention;
Fig. 55 is a schematic cross-sectional view of the digital color camera along a line 55-55 in Figs. 54A to 54C;
Fig. 56 is a block diagram of a still video camera in which the image pickup module of the present invention is applied;
Fig. 57A is a schematic cross-sectional view of a conventional image pickup module;
Fig. 57B is a plan view showing a light shielding member in the conventional image pickup module;
Figs. 58A, 58B, 58C, 58D, 58E, 58F, 58G and 58H are schematic cross-sectional views showing manufacturing steps of the conventional image pickup module;
Fig. 59 is a plan view of a conventional transparent substrate (glass substrate) provided with plural semiconductor chips; and
Fig. 60 is a perspective view of a conventional image pickup module employing distributed refractive index lenses.

### DETAILED DESCRIPTION OF THE PREFERRED EMBODIMENTS

Now the present invention will be clarified in detail by embodiments thereof, with reference to accompanying drawings.

### (Embodiment 1)

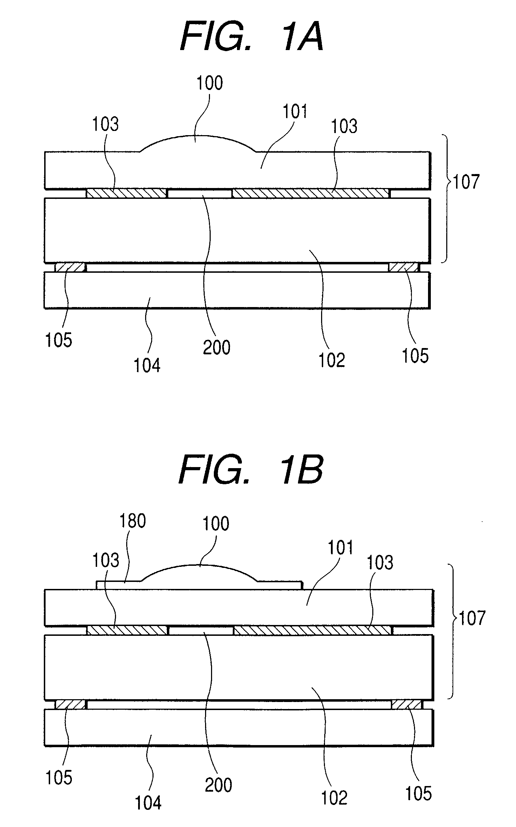

Fig. 1A is a schematic cross-sectional view showing the configuration of an image pickup module constituting an embodiment 1 of the present invention, and Fig. 1B is a schematic cross-sectional view showing another configuration of the image pickup module of the present invention.

Referring to Figs. 1A and 1B, there are shown an upper substrate 101 having a convex lens 100 as a imaging unit, a lower substrate 102, a light shielding diaphragm layer 103 composed of a light shielding member formed on the upper surface of the lower substrate 102 for example by offset printing, a semiconductor chip 104 bearing two-dimensionally pixels (not shown) including photosensor elements, adhesive 105 for adhering the lower substrate 102 and the semiconductor chip 104, a planar resin portion 180 formed around the convex lens 100, a diaphragm aperture 200 defined by the absence of the light shielding diaphragm layer 103 on the upper surface of the lower substrate 102, and an optical element 107 formed by adhering the upper substrate 101 and the lower substrate 102.

In Fig. 1B, the planar resin portion 180 avoids the deterioration of the facial precision of the convex lens 100 in the peripheral portion thereof. The planar resin portion 180 does not reach the end face of the upper substrate 100, and is not therefore cut by the dicing blade in a dicing step to be explained later. The resin is therefore prevented from deposition onto the lens by fusion by frictional heat with the dicing blade or by forming fine fragments or carbon particles, thereby being prevented from deteriorating the quality of the image pickup module.

In the present embodiment, there will be explained the configuration shown in Fig. 1A as an example.

In the optical element 107, in adhering the upper substrate 101 and the lower substrate 102 with transparent adhesive, the adhesion is so executed as not form a gap, thus avoiding formation of an interface between the air and the upper substrate 101 or the lower substrate 102, thereby advantageously preventing ghost image formation.

The upper substrate 101 and the lower substrate 102 are composed of glass or transparent resin, and are formed by glass molding in case of glass, or by injection molding or compression molding in case of transparent resin. The upper substrate 101 may also be formed by adding, to a flat glass substrate, a resinous lens unit formed by a replica process. The lower substrate 102 is preferably composed of borosilicate glass in consideration of stability against temperature change, because of a small difference in the linear dilatation coefficient from the semiconductor chip 104. Also in order to prevent the α-ray induced defect in the semiconductor chip 104, the upper substrate 101 and the lower substrate 102 are both preferably composed of optical glass of a low surfacial α-ray density, and the lower substrate 102 closer to the semiconductor chip 104 preferably has a surfacial α-ray density lower than in the upper substrate 101.

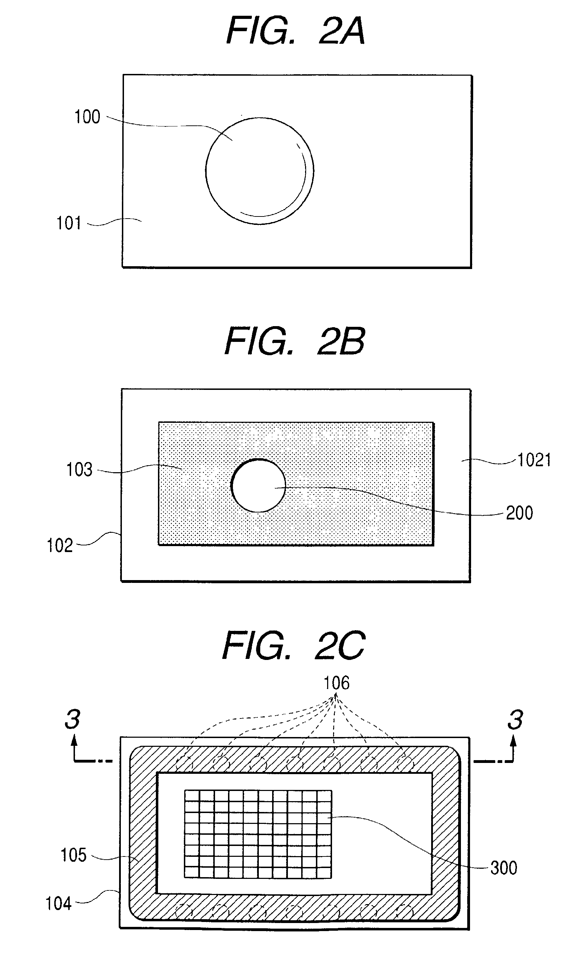

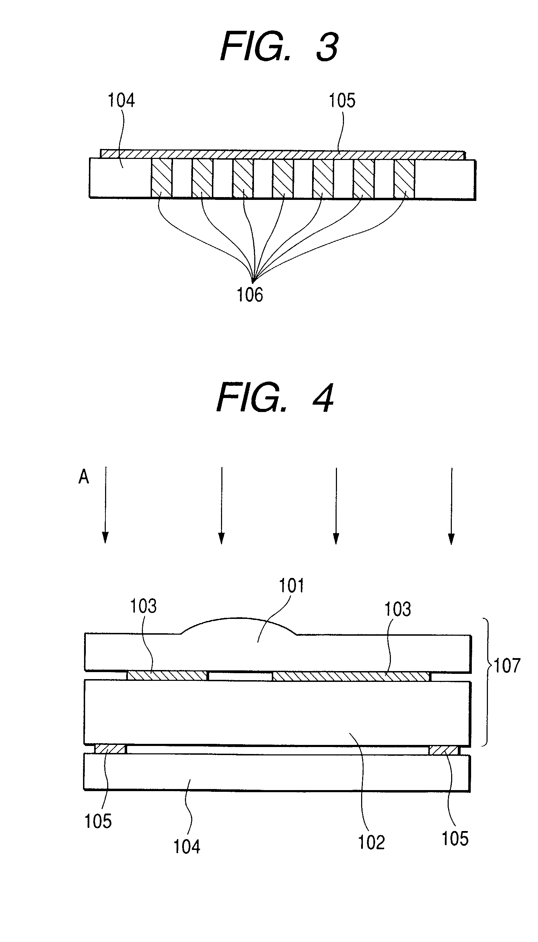

Fig. 2A is a plan view showing the upper substrate 101 constituting the optical element 107 of the image pickup module, while Fig. 2B is a plan view showing the lower substrate 102 constituting the optical element 107, Fig. 2C is a plan view of the semiconductor chip 104, and Fig. 3 is a schematic cross-sectional view thereof along a line 3-3 in Fig. 2C. Also Fig. 4 is a schematic cross-sectional view showing the incident direction of light entering the image pickup module of the present invention.

Referring to Figs. 2A, 2B and 2C, there are shown a transparent area 1021 other than the diaphragm aperture 200 in the peripheral portion of the light shielding diaphragm layer 103, and a penetrating metal member 106 which penetrates the semiconductor chip 104 for electrically connecting a surfacial electrode on a principal surface thereof with a surfacial electrode on the other principal surface thereof.

The image pickup module shown in Fig. 1A has a configuration in which the optical element 107 and the semiconductor chip 104 are integrated to dispense with the sensor package or the lens barrel.

The object light entering the optical element 107 from above in Fig. 1A forms an object image on the semiconductor chip 104.

The optical element 107 is a translucent plate-shaped member formed by adhering the upper substrate 101 and the lower substrate 102.

The convex lens 100 is an axially symmetrical aspherical or spherical lens of a circular shape as shown in Fig. 2A. The position of the diaphragm aperture 200 in the axial direction determines the off-axis principal ray of the optical system, and is extremely important in controlling various aberrations. In case of a lens including a single face convex to the object side, in the absence of a thick air layer between the convex lens 100 and the semiconductor chip 104, the diaphragm is preferably placed in a position between the convex lens 100 and the semiconductor chip 104 and dividing the distance therebetween approximately in a ratio 1:2, in order to satisfactorily correct the aberrations. Thus, as shown in Fig. 2B, a circular diaphragm aperture 200 coaxial with the convex lens 100 is formed by the light shielding layer 103 of the lower substrate 102.

The transparent area 1021 is formed because the range of the light shielding diaphragm layer 103 formed on the lower substrate 102 is limited in order to harden adhesive 105 to be explained later, by ultraviolet irradiation.

More specifically, the presence of the transparent area 1021 enables hardening of the adhesive 105 shown in Fig. 2C by the ultraviolet irradiation from the front side of the semiconductor chip 104 (in a direction A in Fig. 4). In the present specification, the irradiation from the front side of the semiconductor chip 104 means irradiation from the direction A.

The light shielding diaphragm layer 103 is formed by evaporating or sputtering a thin film of inconel, chromel or chromium. In the sputtering process, the transmittance can be arbitrarily controlled as in a printing process, by continuous position control of a shield.

Besides, it is possible to control the MTF of the imaging system by controlling the transmittance within the diaphragm aperture 200 as a function of the distance from the optical axis. In the present embodiment, the transmittance is so selected as to monotonously increase from the peripheral portion to the center in order to reduce the folding distortion resulting from discrete sampling by the photosensor array 300, thereby particularly improving the response in the low spatial frequencies and suppressing the response in the high spatial frequencies.

On the semiconductor chip 104, the optical element 107 forms objects images, which are subjected to photoelectric conversion by the photosensor array 300 to generate an electrical signal. The photosensor array 300 is composed of a two-dimensional array of plural pixels, which may be provided with color filters or with so-called Bayer's RGB filter arrangement for capturing a color image. Also in order to achieve infrared cut-off function, an infrared absorbing element such as copper ions may be contained in either or both of the upper and lower substrates 101, 102.

In the image pickup module shown in Fig. 1A, the electrical connection with an external electrical circuit is executed by rear electrodes since the semiconductor chip 104 is provided thereon with the optical element 107 of a projected shape same as that of the semiconductor chip 104.

In the present embodiment, as an example of such configuration, the penetrating metal member 106 penetrating the semiconductor chip 104 connects the surfacial electrode on a principal surface of the semiconductor chip 104 with the surfacial electrode on the other principal surface thereof.

The optical element 107 and the semiconductor chip 104 are adhered by adhesive 105, which can be ultraviolet settable resin or thermal-ultraviolet settable resin. The adhesive 105 is more preferably thermal-ultraviolet settable resin of sealant type because of ease of thickness control. An example of the thermal-ultraviolet settable resin is epoxy resin mentioned above. In the present embodiment, the adhesive 105 is a sealant formed by screen printing of the thermal-ultraviolet settable epoxy resin. The thermal-ultraviolet settable epoxy resin can be hardened by heating or by ultraviolet irradiation. The epoxy resin is suitable for this application because it shows slow hardening without unevenness in the contraction at the hardening and shows relaxation of the stress. Though there is known adhesive of a type settable by heating, sufficient heating for hardening the thermally settable epoxy resin may deteriorate the unrepresented color filters, replica portion, microlenses or printed paint of the light shielding diaphragm layer 103 formed on the semiconductor chip 104, so that the ultraviolet or thermal/ultraviolet settable resin is more preferable.

The adhesive may be applied not only by screen printing but also by other printing or coating.

The adhesion step is executed by placing the optical element 107 on the semiconductor chip 104, then half hardening the adhesive 105 with ultraviolet irradiation, then executing complete hardening by pressing and applying some heat, and adjusting the gap between the optical element 107 and the semiconductor chip 104 in such a manner that the object image is sharply formed on the photosensor array 300.

The image forming position can be adjusted without requiring a large force, since the gap between the optical element 107 and the semiconductor chip 104 is not completely filled with the resin.

In such operation, since the transparent area 1021 is formed around the light shielding layer 103 in the lower substrate 102 as explained in the foregoing, the adhesive 105 can be easily and securely hardened by the ultraviolet irradiation from the front side of the semiconductor chip (direction A). The transparent area 1021 is only required to be transparent to the ultraviolet light and may be opaque to the light of other wavelengths.

As the adhesive 105 is formed across the transparent area 1021 in the incident direction of the light as explained in the foregoing, there is provided an image pickup module capable of easily sealing the peripheral area of the photosensor array. It is therefore rendered possible to prevent deterioration of the microlenses or the filter layer or electroerosion of the aluminum layer resulting from the dust intrusion or from the humidity in the air.

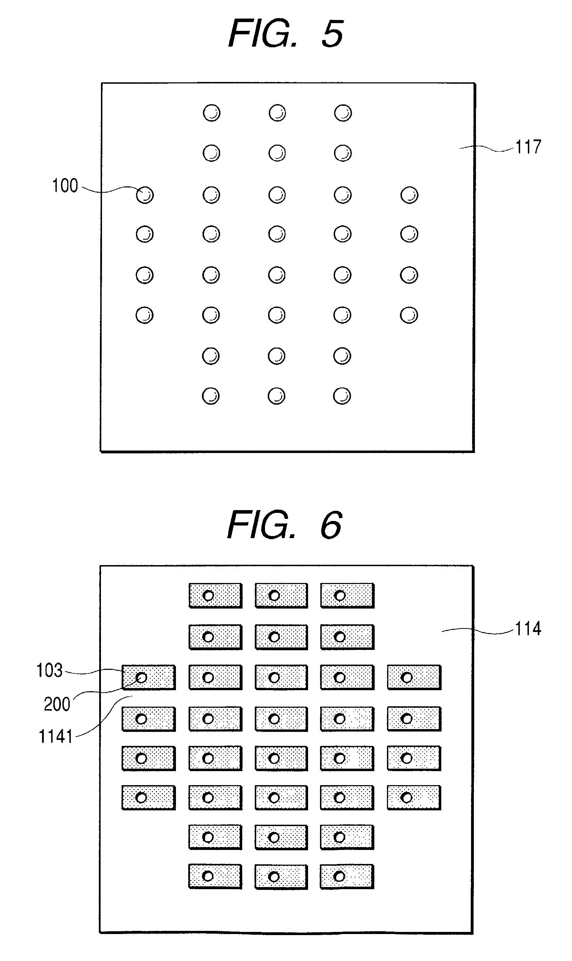

In the following there will be explained a method of mass production of the image pickup module shown in Fig. 1A, with reference to Figs. 5 to 11.

The method is featured in that the optical element 107 and the semiconductor chip 104 are adjoined in a state of an optical element assembly and a semiconductor wafer prior to the cutting thereof. In the present specification, the upper substrate 101 and the lower substrate 102 constituting an image pickup module are called an optical element 107, and a stage prior to the separation into the respective optical element 107 constituting an image pickup module is called an optical element assembly. Similarly a stage prior to the separation into the respective upper substrate 101 is called an upper substrate assembly, and a stage prior to the separation into the respective lower substrate 102 is called a lower substrate assembly. Consequently, the optical element assembly is a large translucent plate-shaped member having an adjoined structure composed of the upper substrate assembly and the lower substrate assembly.

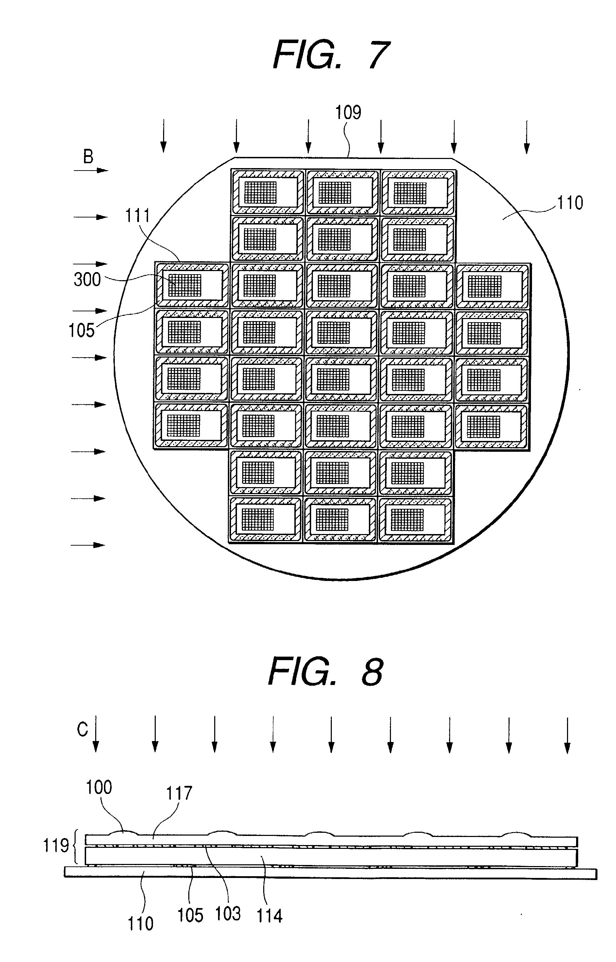

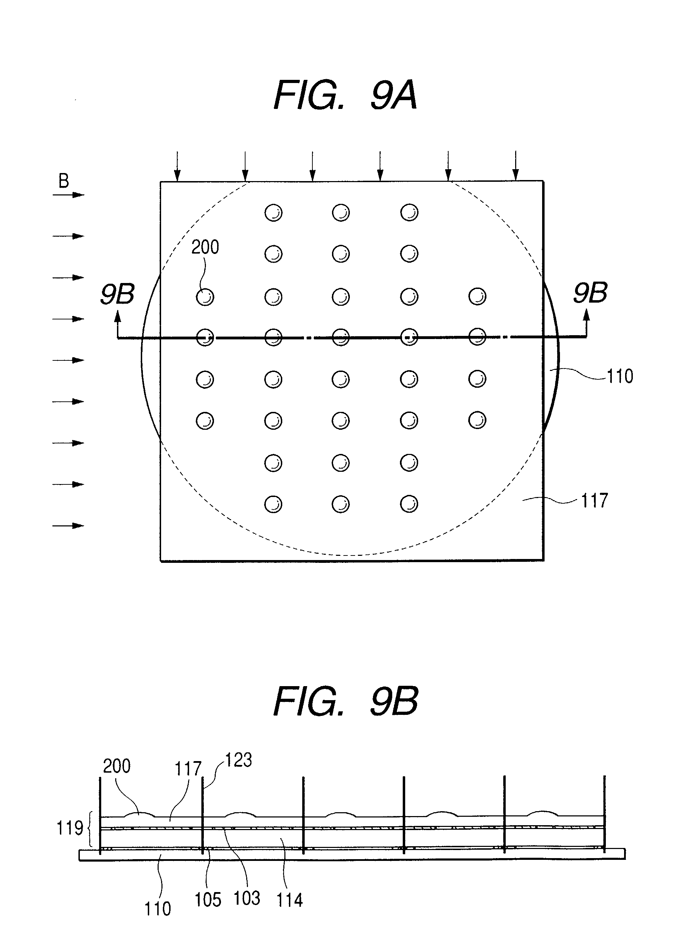

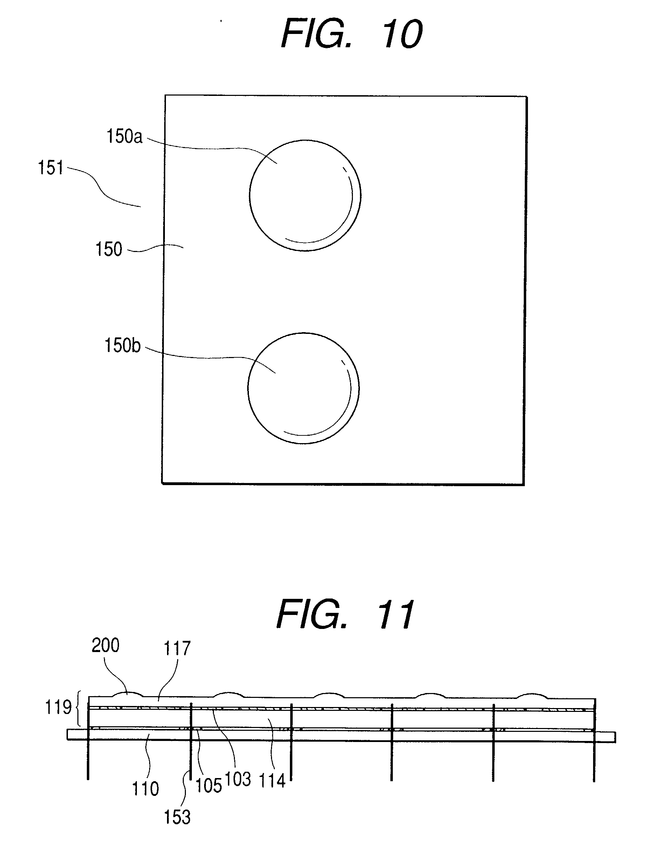

Fig. 5 is a plan view of the upper substrate assembly in the manufacturing process of the image pickup module in the embodiment 1 of the present invention, while Fig. 6 is a plan view of the lower substrate assembly in the manufacturing process of the image pickup module in the embodiment 1 of the present invention, Fig. 7 is a plan view of the semiconductor wafer in the manufacturing process of the image pickup module in the embodiment 1 of the present invention, and Fig. 8 is a schematic cross-sectional view of an adhesive hardening step in the manufacturing process of the image pickup module in the embodiment 1 of the present invention. Also Fig. 9A is a plan view showing a step of separating an image pickup module from an optical element-semiconductor wafer adjoined member in the manufacturing process of the image pickup module in the embodiment 1 of the present invention, while Fig. 9B is a schematic cross-sectional view along a line 9B-9B in Fig. 9A, and Fig. 10 is a plan view showing the upper substrate assembly with two convex lenses formed thereon.

Fig. 5 shows an upper substrate assembly 117; Fig. 6 shows a lower substrate assembly 114 and a transparent area 1141 around the light shielding diaphragm layer 1141; Fig. 7 shows a semiconductor wafer 110, an orientation flat 109 thereof and a boundary line 111 of the adjacent semiconductor chips; and Fig. 8 shows an optical element assembly 119 formed by adjoining the upper substrate assembly 117 and the lower substrate assembly 114.

In the lower substrate assembly 114 shown in Fig. 5, as the external shape of the light shielding diaphragm layer 103 is limited in an island-like shape for the purpose of hardening the ultraviolet settable resin constituting the adhesive to be explained later, the transparent area 1141 is formed around the light shielding diaphragm layer 113.

The position of the diaphragm aperture 200 in the axial direction determines the off-axis principal ray of the optical system and is extremely important in controlling various aberrations. In case of a lens including a single face convex to the object side, in the absence of an air layer between the convex lens 100 and the semiconductor wafer 110 to be explained later, the aberrations can be satisfactorily corrected by placing the diaphragm in a position between the convex lens 100 and the semiconductor wafer 110 and dividing the distance therebetween approximately in a ratio 1:2. Thus, a diaphragm aperture 200 coaxial with the convex lens 100 is formed by the light shielding layer 103 of the lower substrate assembly 104.

The upper substrate assembly 117 and the lower substrate assembly 114 are composed of glass or transparent resin, and are formed by glass molding in case of glass, or by injection molding or compression molding in case of transparent resin. The upper substrate assembly 117 may also be formed by adding, to a flat glass substrate, a resinous lens unit formed by a replica process. The lower substrate assembly 114 is preferably composed of borosilicate glass in consideration of stability against temperature change, because of a small difference in the linear dilatation coefficient from the semiconductor wafer. Also in order to prevent the α-ray induced defect in the semiconductor wafer, the upper substrate assembly 117 and the lower substrate assembly 114 are both preferably composed of optical glass of a low surfacial α-ray density, and the lower substrate closer to the semiconductor wafer preferably has a surfacial α-ray density lower than in the upper substrate 101.

The upper substrate assembly 117 and the lower substrate assembly 114 are adhered with transparent adhesive so as not to form a gap therebetween and not to form an interface between the air and the substrate, thereby preventing ghost image formation.

The convex lens 100 and the diaphragm aperture 200 are provided in plural units on the respective substrates, and are preferably in a coaxial relationship upon adjoining of the substrates. Also the pitch of such convex lenses or such apertures is preferably equal to the pitch of the semiconductor chips formed on the semiconductor wafer.

On the other hand, Fig. 7 is a plan view of the semiconductor wafer. The semiconductor wafer 110 shown in Fig. 7 is provided with a photosensor array and an unrepresented circuit in plural units, which are separated by cutting along the boundary lines 111 and are connected to the external electric circuits, whereby each separated unit functions as a semiconductor chip 104. In Fig. 7, arrows indicate the position and moving direction of a dicing blade in a dicing step to be executed later.

On the semiconductor wafer 110, an object image is formed for each convex lens 100 in the optical element assembly 119, and is subjected to photoelectric conversion by the photosensor array provided in the semiconductor chip to generate an electrical signal.

On the semiconductor chip 104, the optical element 107 forms objects images, which are subjected to photoelectric conversion by the photosensor array 300 to generate an electrical signal. The photosensor array 300 is composed of a two-dimensional array of plural pixels, which may be provided with color filters or with so-called Bayer's RGB filter arrangement for capturing a color image. Also in order to achieve infrared cut-off function, an infrared absorbing element such as copper ions may be preferably contained in either or both of the upper and lower substrate assemblies 117, 114.

As shown in Fig. 8, the optical element assembly 119 and the semiconductor wafer 110 are adhered after the convex lens 100 constituting the imaging unit and the unrepresented photosensor array 300 are aligned in a predetermined relationship.

The semiconductor wafer 110, being crystalline, has anisotropy in electrical, optical, mechanical and chemical properties. Therefore the drawn ingot is sliced after highly precise measurement of the orientation by a method utilizing X-ray diffraction. Prior to the slicing operation, a linear portion, called orientation flat and indicating the crystalline orientation, is formed on the cylindrical ingot. The semiconductor wafer 110 shown in Fig. 7 is provided with such orientation flat 109.

In the preparation step of the semiconductor wafer, the semiconductor element patterns such as the photosensor array 300 are formed with reference to the orientation flat 109. On the other hand, on the optical element assembly 119, for example a reference pattern for the printing of the light shielding diaphragm layer 103 is formed on the lower substrate assembly 114 and is used for the alignment with the orientation flat 109, thereby enabling extremely precise alignment. Besides, such method provides an extremely important advantage that a single alignment of the optical element assembly 119 and the semiconductor wafer 110 completes the alignment on all the image pickup modules to be formed by the cutting in a later step.

The adhesive 105 shown in Fig. 7 is formed by screen printing of the thermal-ultraviolet settable epoxy resin. A sealant of epoxy resin as in the present embodiment is more preferable as it enables easy thickness control. The epoxy resin is suitable for this application because it shows slow hardening without unevenness in the contraction at the hardening and shows relaxation of the stress. Though there is known adhesive of a type settable by heating, sufficient heating for hardening the thermally settable epoxy resin may deteriorate the unrepresented color filters, replica portion, microlenses or printed paint of the light shielding diaphragm layer 103, so that the ultraviolet or thermal/ultraviolet settable resin is more preferable.

The adhesion step is executed by placing the optical element assembly 119 on the semiconductor wafer 110, then half hardening the epoxy resin constituting the adhesive 105 with ultraviolet irradiation, then executing complete hardening by pressing and applying some heat, and adjusting the gap between the optical element assembly 119 and the semiconductor wafer 110 in such a manner that the object image is sharply formed on the photosensor array 300.

In such operation, since the transparent area 1141 is formed around the light shielding layer 103 in the lower substrate assembly 114 as explained in the foregoing, the epoxy resin adhesive 105 can be easily and securely hardened by the ultraviolet irradiation from the front side of the semiconductor wafer (direction C). The fixation by adhesion in the stage of the semiconductor wafer may also provide an effect of preventing a deviated blur in the optical image. The transparent area 1141 is only required to be transparent to the ultraviolet light and may be opaque to the light of other wavelengths.

After the fixation of the optical element assembly 119 and the semiconductor wafer 110, the obtained optical element-semiconductor wafer adjoined member is subjected to a dicing step for cutting such member into individual image pickup modules.

In the following there will be explained this step with reference to Figs. 9A and 9B.

The dicing operation of a semiconductor wafer, a glass substrate or a resin substrate can be executed for example with a cutting apparatus or a laser working apparatus disclosed in the Japanese Patent Application Laid-open No. 11-345785 or the Japanese Patent Publication No. 2000-061677. In case of cutting operation with a dicing blade as explained in the foregoing, a dicing blade 123 shown in Fig. 9B is controlled along arrows B shown in Fig. 9A, under cooling with cooling water. In the actual cutting operation, the cutting may be executed by advancing the optical element-semiconductor wafer adjoined member or by simultaneous cutting of the adjoined member with plural dicing blades.

In the dicing operation, there is utilized a dicing mark which can be a groove formed by etching on the lower substrate assembly 114 or the upper substrate assembly 117, a metal mark formed by photolithography or a resinous protrusion formed by a replica process. In particular, the simultaneous replica formation of such mark with the lens constituting the imaging unit allows to reduce the manufacturing steps.

In the dicing step of the optical element-semiconductor wafer adjoined member, there is executed half-cut dicing in which the semiconductor wafer 110 is left uncut by a thickness of 50 to 100 µm. Since the adhesive 105 for adhering the semiconductor wafer 110 and the optical element assembly 119 is provided excluding the dicing position of the semiconductor wafer 110, the adhesive is prevented from deposition onto the lens by fusion by frictional heat with the dicing blade or by forming fine fragments or carbon particles, thereby being prevented from deteriorating the quality of the image pickup module.

Also the use of a laser working apparatus in the dicing operation of the semiconductor element allows to suppress the generation of glass particles, thereby improving the production yield. It is also possible to introduce the dicing blade from the side of the semiconductor wafer 110 as shown in Fig. 11 and to execute half-cut dicing in which the upper substrate assembly 117 is left uncut by a thickness of 50 to 100 µm.

In a breaking step succeeding to the dicing step, the uncut portion of 50 to 100 µm in the semiconductor wafer 110 or the upper substrate assembly 117 is broken with predetermined rollers.

The image pickup module obtained by cutting in the foregoing steps is same as that of the configuration shown in Fig. 1A. The electrical connection with the external electrical circuit may be achieved, as explained in the foregoing, by the rear electrode connected with the penetrating metal member shown in Fig. 3.

The optical element assembly need not necessarily be provided with the optical elements of a number same as that of the semiconductor chips formed on the semiconductor wafer. For example, the optical element assembly 151 shown in Fig. 10 is provided with two convex lenses 150a, 150b on the upper substrate 150 while the semiconductor wafer 110 shown in Fig. 7 is provided with 16 optical element assemblies 150, and the succeeding dicing step cuts each into two optical elements to eventually obtain 32 image pickup elements.

By forming the optical elements on the optical element assembly in a number smaller than that of the semiconductor chips formed on the semiconductor wafer and forming a certain gap between the optical elements, the positional relationship between the optical element and the semiconductor chip is scarcely deteriorated even in case the flatness of the semiconductor wafer, maintained highly precisely by suction of the rear surface to a jig, is worsened when the suction is terminated. Even in the recent trend of increase in the diameter of the semiconductor wafer, such configuration allows to easily obtain a high production yield.

Such sealing with the adhesive 105 allows to prevent deterioration of the microlenses or the filter layer or electroerosion of the aluminum layer resulting from dust intrusion or humidity in the air. Such sealing is even more effective since it is executed in the semiconductor manufacturing process.

### (Embodiment 2)

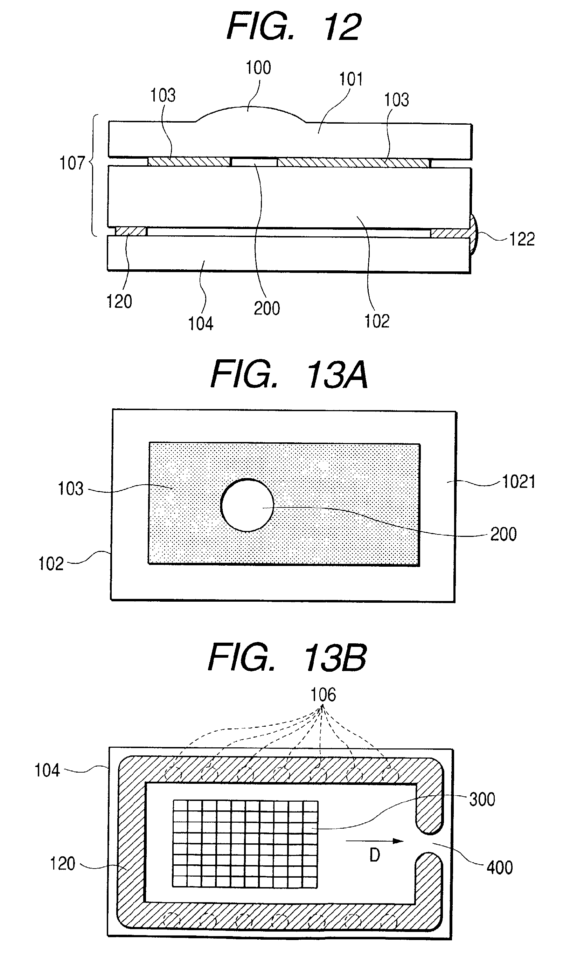

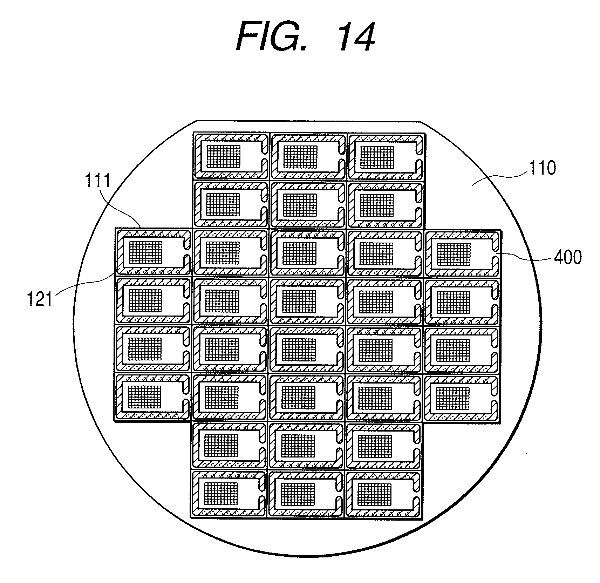

In the following there will be explained the image pickup module of the embodiment 2 of the present invention, with reference to Figs. 12 to 14. Fig. 12 is a schematic cross-sectional view of an image pickup module of the embodiment 2 of the present invention, Fig. 13A is a plan view of the lower substrate constituting the optical element of the image pickup module of the embodiment 2 of the present invention, Fig. 13B is a plan view of the upper substrate constituting the semiconductor chip of the image pickup module of the embodiment 2 of the present invention, and Fig. 14 is a plan view of the semiconductor wafer in adhering the optical element assembly and the semiconductor wafer in the manufacturing process of the the image pickup module of the embodiment 2 of the present invention.

Fig. 12 shows a sealant 120 constituting the adhesive and adhesive 122 formed for sealing an aperture 400, and Figs. 13A and 13B show an aperture 400 so provided that the sealant 120 does not completely surround the photosensor array 300.

Components equivalent to those explained in the foregoing are represented by like numbers and will not be explained further.

The present embodiment is different from the first embodiment in that the adhesive in adhering the optical element 107 and the semiconductor chip 104 has a shape suitable for improving the imaging performance and also obtaining high precision in the alignment of the optical element 107 and the semiconductor chip 104.

More specifically, in a pressing step for adhering the optical element 107 and the semiconductor chip 104, a certain pattern of the sealant 120 allows the gas, enclosed in an area surrounded by the semiconductor chip 104, the optical element 107 and the sealant 120, to escape through an aperture 400 whereby the internal pressure does not increase.

Consequently there can be avoided undesirable repulsive force applied to the optical element 107 or gradual movement of the sealant 120 by the viscous nature thereof from the internal side to the external side along with the pressure increase in the interior, whereby the alignment of the optical element 107 and the semiconductor chip 104 can be advantageously achieved in more precise manner.

More specifically, the effect of the gap, without being filled with the resin, between the optical element 107 and the semiconductor chip 104 already explained in the foregoing first embodiment can be exploited more strongly.

The adhesive is not limited to the sealant 120 but may also be composed of ultraviolet settable resin. The present embodiment employs epoxy resin which is thermal-ultraviolet settable resin and also functions as a sealant.

After the sealant 120 is completely hardened by ultraviolet irradiation from the front side of the semiconductor chip 104, the aperture 400 of the sealant 120 is closed with adhesive 122. The adhesive 122 is preferably composed of thermal-ultraviolet settable resin, and, in the present embodiment, of epoxy resin same as the sealant 120. The adhesive 122 is also hardened by the ultraviolet irradiation from the front side of the semiconductor chip 104.

The adhesives 120 and 122 may be suitably hardened not only by ultraviolet irradiation but also by heat.

Therefore, as in the embodiment 1, the transparent area 1021 is provided in order to limit the range of the light shielding diaphragm layer 103, thereby enabling hardening of the epoxy resin 122 by the ultraviolet irradiation from the front side of the semiconductor chip 104. It is therefore possible to arrange multiple image pickup modules in parallel manner and to simultaneously execute the ultraviolet irradiation, thus achieving a significant advantage in cost.

Otherwise, as in the embodiment 1, the optical element and the semiconductor chip may be adhered in a stage of the optical element assembly and the semiconductor wafer prior to the cutting, as shown in Fig. 14. The configurations in Figs. 14 and 2C are different in the pattern of the adhesive, as explained in the foregoing. The adhesive 120 of the present embodiment is provided with the aperture 400, so that, in pressing the optical element assembly onto the semiconductor wafer 110, the gas emerging from the aperture can escape to the exterior through the boundary lines 111 of the semiconductor chips, so that the undesirable repulsive force cannot be applied to the optical element assembly and the alignment with the semiconductor wafer 110 can be achieved with a high precision. Also there can naturally be obtained the advantages of the embodiment 1.

### (Embodiment 3)

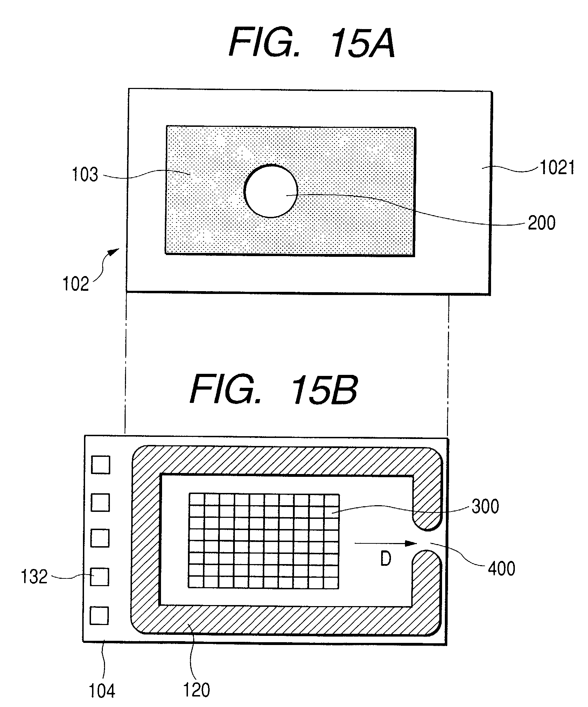

In the following there will be explained the image pickup module of an embodiment 3 of the present invention, with reference to Figs. 15 to 23.

The present embodiment is different from the embodiment 2 in having an optimum configuration for achieving connection with the external electrical circuit through the surface electrode.

Also there is shown an example in which the resin thickness is reduced on the dicing line in the dicing step for cutting the optical element-semiconductor wafer adjoined member into the image pickup modules.

Fig. 15A is a plan view showing the lower substrate of the image pickup module of the embodiment 3 of the present invention, and Fig. 15B is a plan view of the semiconductor chip of the image pickup module of the embodiment 3.

Figs. 15A and 15B show electrode pads 132 of the semiconductor chip 104.

Components equivalent to those explained in the foregoing are represented by like numbers and will not be explained further.

Two chain lines between Figs. 15A and 15B indicate the positional relationship between the lower substrate 102 and the semiconductor chip 104 in the present image pickup module, and indicate that the lower substrate 102 and the semiconductor chip 104 are fixed in a state displaced by a certain distance in the lateral direction of the drawings. The lower substrate 102 and the semiconductor chip 104 preferably have a same external dimension because of each of the manufacturing process.

As shown in Fig. 15B, the connection with the external electrical circuit is to be made by electrode pads 132 formed in an upward open position which there is no sealant on its above of an end portion of the semiconductor chip 104, and the sealant 120 is positioned inside the electrode pads 132. Also for enabling ultraviolet irradiation on the thermal-ultraviolet settable resin constituting the sealant 120 formed on the semiconductor chip 104 as in the embodiment 1, the light shielding diaphragm layer 103 of the lower substrate 102 is formed inside the sealant 120, and the transparent area 1021 is positioned directly above the sealant 120.

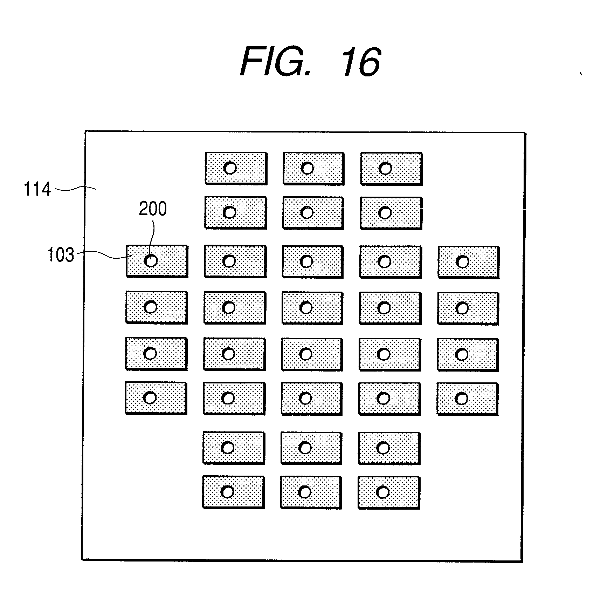

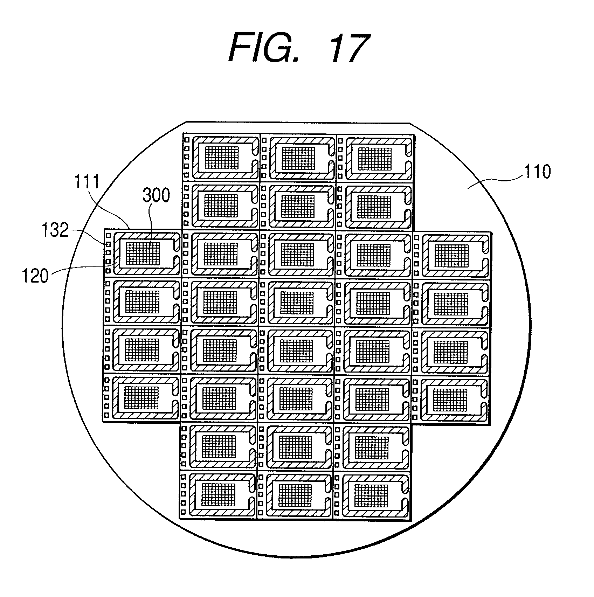

Figs. 16 and 17 illustrate a lower substrate and a semiconductor wafer, satisfying such positional relationship, in a stage prior to cutting.

Fig. 16 is a plan view of a lower substrate assembly in the manufacturing process of the image pickup module of the embodiment 3 of the present invention, and Fig. 17 is a plan view of a semiconductor wafer in the manufacturing process of the image pickup module of the embodiment 3 of the present invention.

In the present embodiment, the upper substrate assembly is adhered after the lower substrate assembly and the semiconductor wafer are adhered. In such process, the ultraviolet light for irradiating the sealant 120 can reach the same only after passing through the lower substrate 102, whereby the light absorption in the substrate can be reduced. Consequently the ultraviolet settable resin can be hardened with a lower light amount and with a shorter time, whereby the manufacturing process can be shortened.

The adhering step of the lower substrate assembly 114 and the semiconductor wafer 110 is similar to that in the embodiment 1.

The adhesive may have the pattern of the sealant 105 in the embodiment 1, but, in the present embodiment, assumes the pattern of the sealant 120 explained in the embodiment 2.

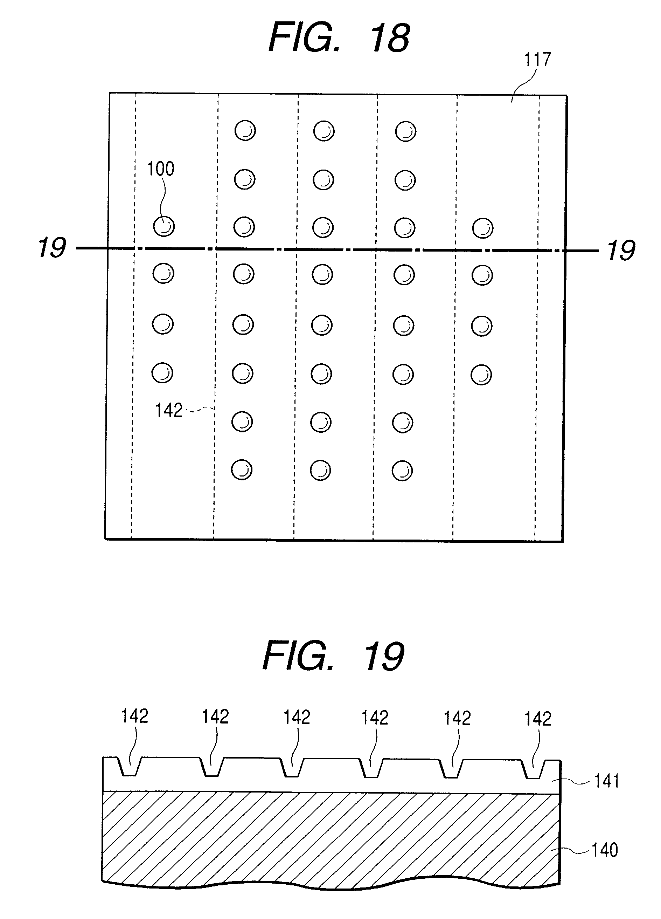

Fig. 18 is a plan view of the upper substrate assembly in the manufacturing process of the image pickup module of the embodiment 3 of the present invention. It is fixed onto the lower substrate assembly 118 to form the optical element assembly.

In Fig. 18 there are shown dicing lines 142 (vertical ones only).

Fig. 19 is a schematic cross-sectional view along a line 19-19 in Fig. 18. The dicing line 142 is formed by locally reducing the thickness of resin 141 formed on the glass substrate 140. The dicing mark may also be formed by a replica method simultaneous with the formation of the convex lens 100, thereby reducing the manufacturing steps. The dicing mark may be a groove formed for example by etching on the lower substrate assembly 114 or the upper substrate assembly 117, or a metal mark formed by photolithography, or a protruding portion of resin formed by a replica method.

Since the resin is merely made thinner at the dicing line 142 but is not interrupted, the convex lens 100 can be easily formed also by injection molding, by setting the molding gate at the end portion of the upper substrate assembly 117. The upper substrate assembly 117 is fixed to the lower substrate assembly 114 after precise alignment with the semiconductor wafer 133.

In the following there will be explained the dicing step for separating thus prepared optical element-semiconductor wafer adjoined member into the image pickup modules.

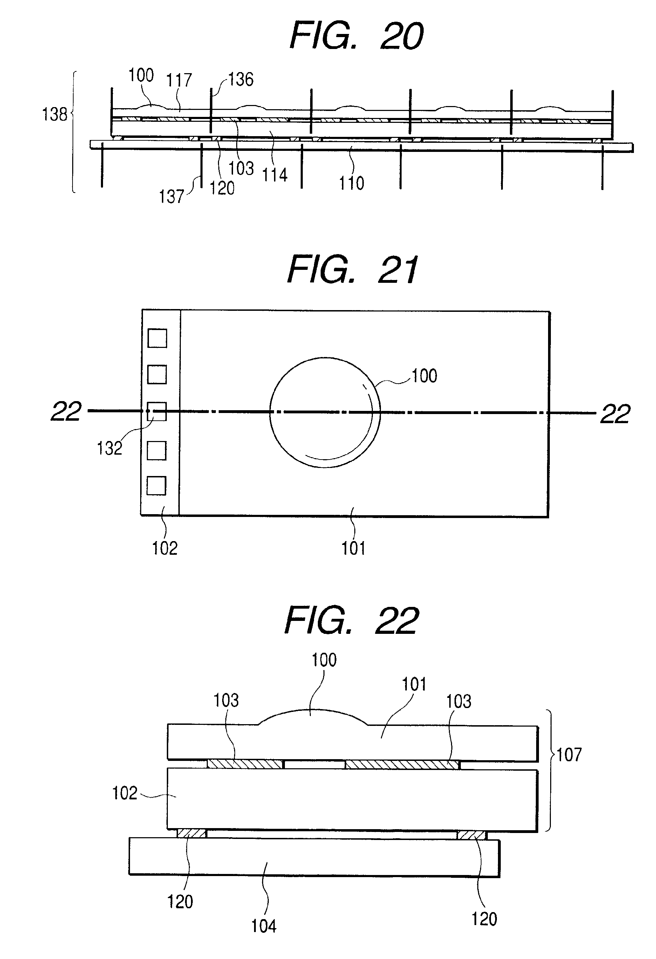

Fig. 20 is a schematic cross-sectional view showing the dicing step for the optical element-semiconductor wafer adjoined member in the manufacturing process for the image pickup module of the embodiment 3 of the present invention.

In Fig. 20, there are shown an optical element-semiconductor wafer adjoined member 138 formed by adhering the upper substrate assembly 117, lower substrate assembly 114 and semiconductor wafer 110, a dicing blade 136 for dicing the optical element assembly 119 composed of the upper substrate assembly 117 and the lower substrate assembly 114, and a dicing blade 137 for dicing the semiconductor wafer 110.

In the present embodiment, the dicing is executed from the upper and lower faces of the optical element-semiconductor wafer adjoined member 138. In the dicing operation, dicing blades 136, 137 may be controlled along the position shown in Fig. 20, under cooling with cooling water.

In the dicing operation, the dicing may be executed by advancing the optical element-semiconductor wafer adjoined member 138 or by simultaneous dicing of the adjoined member with plural dicing blades. Also the dicing may be executed on each of the upper and lower faces at a time or on both faces at the same time.

In the dicing operation, since the resin 141 constituting the dicing line 142 is made sufficiently thin, the resin 141 is almost prevented from deposition onto the lens by fusion by frictional heat with the dicing blade or by forming fine fragments or carbon particles, thereby being prevented from deteriorating the quality of the image pickup module.

In this dicing step, there is executed half-cut dicing in which the semiconductor wafer 110 and the lower substrate assembly 114 are left uncut by a thickness of 50 to 100 µm. In a breaking step succeeding to the dicing step, the uncut portion of 50 to 100 µm in the semiconductor wafer 133 is broken with predetermined rollers.

Fig. 21 is a plan view of the image pickup module of the embodiment 3 of the present invention, and Fig. 22 is a schematic cross-sectional view of the image pickup module shown in Fig. 21, along a line 22-22 therein.

The semiconductor chip 104 extends to the rear of the upper substrate 101, and the electrode pads 132 are positioned in such rear position. In the present embodiment, the optical element 107, consisting of the upper substrate 107 and the lower substrate 102, and the semiconductor chip 104 are adhered or fixed in a state mutually displaced in a direction by a predetermined amount.

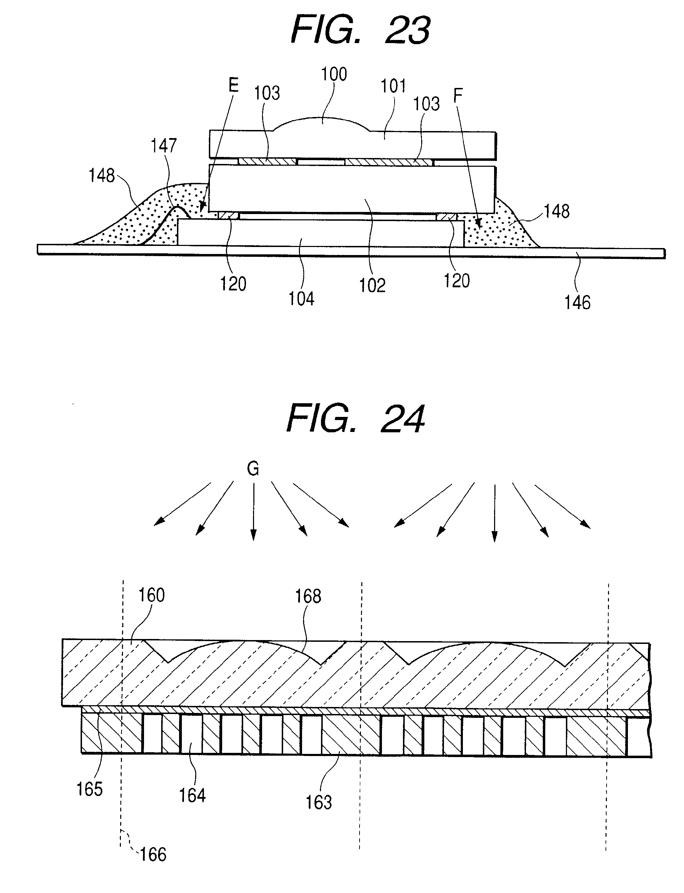

Fig. 23 is a schematic cross-sectional view showing the connection state with the external electrical circuit and the seal state of the image pickup module of the embodiment 3 of the present invention.

Referring to Fig. 23, there are shown a flexible printed circuit board 146 constituting an external electrical circuit board, a bonding wire 147 for electrically connecting the electrode pad 132 of the image pickup module 154 with an electrode pad (not shown) of the flexible printed circuit board 146, and thermal-ultraviolet settable resin 148 for sealing the periphery of the electrode pad and the bonding wire 147.
The thermal-ultraviolet settable resin 148 is coated over the entire periphery of the image pickup module 154, in order to achieve secure mounting of the flexible printed circuit board 146 onto the image pickup module 154. The thermal-ultraviolet settable resin is selected because sufficient heating for hardening the thermally settable epoxy resin may deteriorate the unrepresented color filters formed on the semiconductor wafer 133, replica portion, microlenses or printed paint of the light shielding diaphragm layer 103.

For hardening the thermal-ultraviolet settable resin 148, there is principally executed ultraviolet irradiation from above the upper substrate 140. In order to avoid erosion of the electrode pads 132 of the semiconductor chip 140, the close contact between the lateral face of the lower substrate 102 and the thermal-ultraviolet settable resin 148 is extremely important.

In case the range of the light shielding diaphragm layer 103 is not limited to the interior of the sealant 120, the ultraviolet light reaches the sealing portion of the lower substrate 102 through the layer of the thermal-ultraviolet settable resin 148, so that such portion hardens latest. In the present image pickup module, however, since the range of the light shielding diaphragm layer 103 is limited to the interior of the sealant 120, there is secured an optical path for the ultraviolet light to the sealing portion of the lower substrate 102 as indicated by an arrow E and such optical path allows to achieve secure hardening and sealing of the thermal-ultraviolet settable resin 148 without going through the layer thereof. Also an optical path indicated by an arrow F provides high mounting stability to the flexible printed circuit board 146.

As explained in the foregoing, the sealing with the sealant 120 and the thermal-ultraviolet settable resin 148 allows to securely prevent deterioration of the microlenses or the filter layer and electroerosion of the aluminum layer, resulting from the dust intrusion or by the humidity in the air. Also the electrical connection from the surface electrode to the external electrical circuit by the bonding wire enables manufacture at a low cost, without requiring an ITO film or a penetrating metal member. The configuration of the present embodiment is applicable also to the electrical connection not employing the bonding wire but utilizing a TAB film.

### (Embodiment 4)

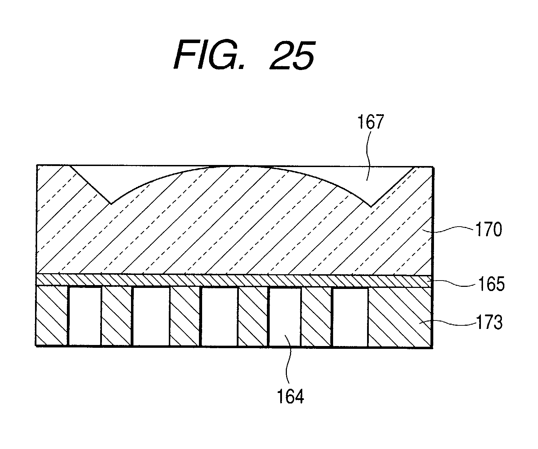

In the following there will be explained an embodiment 4 of the present invention, with reference to Figs. 24 and 25.

The present embodiment is different from the embodiments 1 to 3 in that the optical element is provided with a recess in such a manner that the resin does not protrude from the surface.

Fig. 24 is a schematic cross-sectional view showing an ultraviolet irradiating step to the optical element-semiconductor wafer adjoined member in the manufacturing process for the image pickup module of the embodiment 4 of the present invention.

Referring to Fig. 24, there are shown a semiconductor wafer 163 bearing plural semiconductor chips, an adhesive layer 165, an optical element assembly 160 having a convex face formed on the bottom of each of plural recesses and to be cut off into an optical element to be mounted on an image pickup module, and a resin layer 168 for filling and planarizing the recesses of the optical element assembly 168. The resin layer 168 has a refractive index lower than that of the optical element assembly 160 to perform the function of a convex lens 161, wherein the interface constitutes a imaging unit. Since the optical element assembly 160 is planarized by the resin layer 168, such planarized portion may be utilized for easy mounting of the image pickup module to a supporting member. There is also shown a penetrating metal member 164 which penetrates the semiconductor chip for forming a rear electrode and serves to achieve electrical connection with the external electrical circuit by such rear electrode.

Components equivalent to those explained in the foregoing are represented by like numbers and will not be explained further.

The optical element assembly 160 is composed for example of glass. The adhesive layer 165 may be so formed as to surround the photosensor array of the semiconductor chip as in the foregoing embodiments 1 and 2, but it may also be formed on the entire surface of the semiconductor chip. In such case, however, the adhesive layer 165 is preferably formed excluding the dicing position.

The semiconductor wafer 163 is provided with plural electrical circuits which are to be later cut off into the individual semiconductor chips and each of which is provided with a photosensor array. The imaging unit consisting of the optical element assembly 160 and the resin layer 168 has such an optical path length capable of forming an object image on the semiconductor wafer 163, and the pitch of such imaging units is equal to the pitch of the semiconductor chips formed on the semiconductor wafer 163.

The principal steps for completing the image pickup module are, as in the foregoing embodiments, a known step of forming the circuit pattern on the semiconductor wafer 163, a step of forming the lens on the optical element assembly 160, a step of alignment and adhesion of the semiconductor wafer 163 and the optical element assembly 160, and a dicing step.

In the alignment-adhesion step, at first the space between the semiconductor wafer 163 and the optical element assembly 160 is filled by the adhesive layer 165 of the thermal-ultraviolet settable epoxy resin without forming an air layer therein to set the gap between the optical element assembly 160 and the semiconductor wafer 163 in such a manner that the object image can be sharply formed. Though there is known adhesive of a type settable by heating, the adhesive of thermal/ultraviolet settable type is selected because sufficient heating for hardening the thermally settable epoxy resin may deteriorate the unrepresented color filters or the resin layer formed on the semiconductor wafer 163.

Then diffuse ultraviolet irradiation is executed as indicated by an arrow G in Fig. 24 to harden the epoxy resin of the adhesive layer 165 thereby fixing the semiconductor wafer 163 and the optical element assembly 160. In case of parallel light irradiation, the irradiating light converges to a point on the optical axis by the focusing function of the imaging unit, but, in case of the diffuse irradiation employed in the present embodiment, the ultraviolet light reaches the entire adhesive layer 165 positioned below the imaging unit whereby the adhesive layer 165 can be hardened sufficiently.

In a succeeding dicing step, the cutting is executed by full dicing along the boundary lines 166 shown in Fig. 24. Each cut piece functions as an image pickup module by connection to the external electrical circuit. Since the optical element assembly 160 is provided with a recess in such a manner that the resin does not protrude from the surface and that the resin is excluded from the passing position of the dicing blade, the resin can be prevented from depositing on the lens surface by fusion induced by the friction with the dicing blade or by forming fine particles or carbon particles whereby the image pickup module can be prevented from deterioration in quality.

Fig. 25 is a schematic cross-sectional view of the image pickup module of the embodiment 4 of the present invention.

In Fig. 25, there are shown a semiconductor chip 173, an adhesive layer 165, and an optical element 170 cut off from the optical element assembly.

In the present embodiment, the sealing with the adhesive layer 165 allows to securely prevent deterioration of the filter layer or electroerosion of the aluminum layerof the semiconductor chip 173, resulting from the dust intrusion or by the humidity in the air. Such sealing is even more effective since it is executed in the stage of semiconductor wafer. It is also possible to significantly reduce the number of the adjusting steps since the alignment with the optical elements can be achieved at a time in the stage of semiconductor wafer.

### (Embodiment 5)

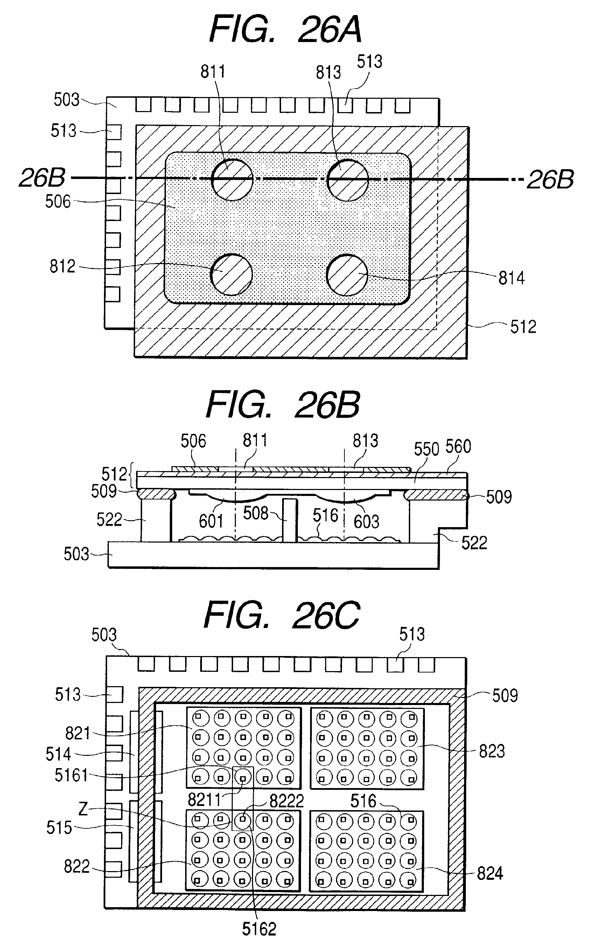

Fig. 26A is a plan view of an image pickup module of the embodiment 5 of the present invention, Fig. 26B is a schematic cross-sectional view along a line 26B-26B in Fig. 26A, and Fig. 26C is a plan view of a semiconductor chip constituting the image pickup module of the embodiment 5 of the present invention.

Referring to Figs. 26A and 26B, there are shown an infrared cut-off filter 560, a translucent plate-shaped member 550, a light shielding diaphragm layer 506 formed by a light shielding member for example by offset printing on the upper face of the translucent plate-shaped member across the infrared cut-off filter 550, an infrared cut-off filter 512, and a stereoscopic optical element including a light shielding diaphragm layer 506 and stereoscopic lenses consisting of convex lenses 601, 603 and unrepresented convex lenses 602, 604 and serving as a imaging unit. The convex lenses 602, 604 are not illustrated in Fig. 26B but are coaxial with diaphragm apertures to be explained later. There are also shown a semiconductor chip 503 bearing two-dimensionally arranged pixels (not shown) including photosensors, a spacer 522 for defining the distance between the stereoscopic optical element 512 and the semiconductor chip 503, ultraviolet settable resin 509 for adhering the stereoscopic optical element 512 and the semiconductor chip 503 across the spacer 522, diaphragm apertures 811, 812, 813, 814 formed on the upper surface of the stereoscopic optical element 512 but not bearing the light shielding diaphragm layer 506, electrode pads 513 serving as external terminals, a light shielding portion 508 formed in a space surrounded by the stereoscopic optical element 512, spacer 522 and semiconductor chip 503 for avoiding optical crosstalk of the four convex lenses, a microlens 516 for improving the light condensing efficiency of each photosensor, photosensor arrays 821, 822, 823, 824 formed in plural units in two-dimensional manner on the semiconductor chip 503, an AD conversion circuit 512 for converting the output signals of the photosensor arrays 821, 822, 823, 824 into digital signals, and a timing generator 515 for generating a timing signal for the photoelectric converting operation for the photosensor arrays 821, 822, 823, 824.

In the image pickup module of the present embodiment, the stereoscopic optical element 512 and the semiconductor chip 503 are integrated to dispense with the sensor package or the lens barrel.

As in other embodiments, the object light entering the stereoscopic optical element 512 from above in Fig. 26B forms plural object images the semiconductor chip 503, and each photosensor therein executes photoelectric conversion.

The convex lenses 811 to 814 are resinous Fresnel convex lenses formed on the lower face of the stereoscopic optical element 512 formed for example by a replica process. In addition to the replica process, it is also possible to form the convex lenses with a resinous material by injection molding or compression molding together with the substrate. The convex lenses 601, 602, 603, 604 are axially symmetrical aspherical or spherical Fresnel convex lenses of circular shape, capable of satisfactorily correcting in particular the curvature of image plane in comparison with the ordinary optical system employing continuous surface.

On the upper face of the translucent plate-shaped member 550 there are provided a light shielding diaphragm layer 506 and an infrared cut-off filter 560. The infrared cut-off filter 560 can be composed of an infrared cut-off filter utilizing light interference in dielectric multiple layers and formed by evaporation on the entire surface of the translucent plate-shaped member 550, and the light shielding diaphragm layer 506 can be formed thereon. Such process does not require a mask at the evaporation and is therefore advantageous in cost. The infrared cut-off filter is formed if necessary and may also be dispensed with. A thinner image pickup module can be obtained in the absence of the infrared cut-off filter.

In the present embodiment, as in the foregoing embodiments, the external shape of the light shielding diaphragm layer 506 is limited in an island-like shape for the purpose of hardening the ultraviolet settable resin constituting the adhesive 509 to be explained later. In the present embodiment, the adhesive 509 is composed of epoxy resin which serves as a sealant of a pre-controlled thickness and is thermal-ultraviolet settable resin.

The position of the diaphragm apertures 811, 812, 813, 814 in the axial direction determines the off-axis principal ray of the optical system, and is extremely important in controlling various aberrations. In the imaging unit consisting of a Fresnel lens convex to the image side, the diaphragm is advantageously positioned in the vicinity of the center of a spherical plane approximating the Fresnel lens surface in order to satisfactorily correct the aberrations. Consequently, as shown in Fig. 26A, four circular diaphragm apertures 811, 812, 813, 184 are formed on the upper face of the stereoscopic optical element 512.

On the semiconductor chip 503, the stereoscopic optical element 512 forms four object images, which are subjected to photoelectric conversion by the four photosensor arrays 821, 822, 823, 824 provided on the semiconductor chip 503 and are captured as electrical signals. Each photosensor is provided with a microlens 516 for improving the light condensing efficiency. The four photosensor arrays are respectively provided with a green (G) transmitting filter, a red (R) transmitting filter, a blue (B) transmitting filter and a green (G) transmitting filter to obtain four images which are color separated in three primary colors.

The distance between the semiconductor chip 503 and the stereoscopic optical element 512 is determined by the sum of the thickness of the spacer 522 and that of the adhesive 509 positioned thereon and consisting of the thermal-ultraviolet settable epoxy resin. The spacer 522 is formed by adhering a member of resin, glass, silicon etc. to the semiconductor chip. For fixing the spacer 522 to the semiconductor chip 503, there may be applied an adhering step in producing a SOI (silicon on insulator) substrate.

Also in adhering the stereoscopic optical element 512 and the spacer 522, the thickness of the sealant 509 can be adjusted to execute fine adjustment of the gap between the stereoscopic optical element 512 and the semiconductor chip 503. Such adhesion step is executed in the stage of semiconductor wafer.

On the semiconductor chip 503, the stereoscopic optical element 512 forms four object images of RGBG colors, which are subjected to photoelectric conversion by the four photosensor arrays 821, 822, 823, 824 provided on the semiconductor chip 503 and are captured as electrical signals. Each photosensor is provided with a microlens 516 for improving the light condensing efficiency whereby the image pickup module can easily capture the image of even an object of a low luminance.

Also the microlenses 516 are eccentrically positioned with respect to the photosensors of the semiconductor chip 503, and the amount of such eccentricity is zero at the center of each photosensor array 821, 822, 823 or 824 but becomes larger toward the peripheral portion thereof. The direction of eccentricity is along a line connecting the center of each photosensor array and each phtosensor.

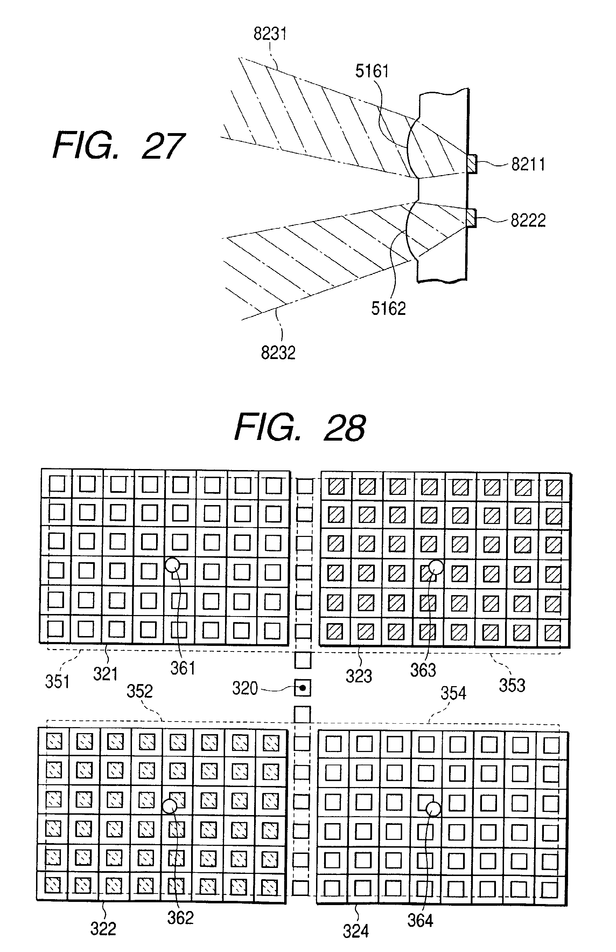

Fig. 27 is a magnified schematic cross-sectional view of a region Z in Fig. 26C, for explaining the function resulting from the eccentric positioning of the microlens 516. A microlens 5161 is eccentrically positioned in the upper direction in the direction with respect to a photosensor 8211, while a microlens 5162 is eccentrically positioned in the lower direction with respect to a photosensor 8222. As a result, the light beam entering the photosensor 8211 is limited to a hatched area 8231, while the light beam entering thephotosensor 8222 is limited to a hatched area 8232.

The light beam areas 8231, 8232 are inclined in respectively opposite directions, and are respectively directed toward the diaphragm apertures 811, 812. Consequently, by suitably selecting the amount of eccentricity of the microlenses 516, each photosensor array only receives the light beam emerging from a specified diaphragm aperture. More specifically, the amount of eccentricity can be so selected that the object light passing through the diaphragm aperture 811 is photoelectrically converted principally in the photosensor array 821, the object light passing through the diaphragm aperture 812 is photoelectrically converted principally in the photosensor array 822, the object light passing through the diaphragm aperture 813 is photoelectrically converted principally in the photosensor array 823 and the object light passing through the diaphragm aperture 814 is photoelectrically converted principally in the photosensor array 824.

In the following there will be explained the positional relationship between the object image and the image pickup area and the positional relationship of the pixels when projected on the object.

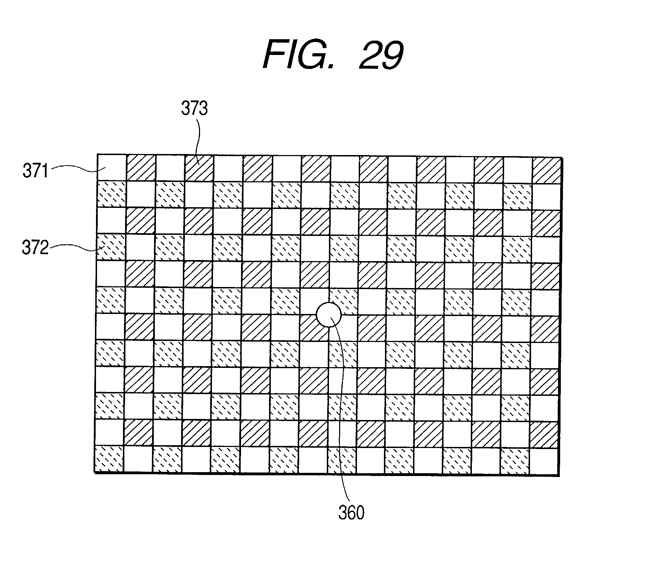

Fig. 28 is a view showing the positional relationship between the object image formed by the stereoscopic lenses and the image pickup area in the image pickup module of the embodiment 5 of the present invention, and Fig. 29 is a view showing the positional relationship of the pixels when the image pickup area shown in Fig. 28 is projected.

In Fig. 28, there are shown four photosensor arrays 321, 322, 323, 324 of the semiconductor chip 503. For the purpose of simplicity, each of the photosensor arrays 321, 322, 323, 324 is composed of 8 × 6 pixels. The photosensor arrays 321, 324 output the G image signal, while the photosensor array 322 outputs the R image signal, and the photosensor array 323 outputs the B image signal. The pixels in the photosensor arrays 321, 324 are indicated by white rectangles, while those in the photosensor array 322 are represented by hatched rectangules, and those in the photosensor array 323 are indicated by black rectangles.

Between the photosensor arrays, there are formed separating belts of a dimension of a pixel in the horizontal direction and three pixels in the vertical direction. Consequently, the distance between the centers of the photosensor arrays outputting the G images is same in the horizontal and vertical directions. There are also shown object images 351, 352, 353, 354. For the purpose of pixel displacement, the centers 361, 362, 363, 364 of the object images 351, 352, 353, 354 are respectively offset by 1/4 of a pixel from the centeres of the photosensor arrays 321, 322, 323, 324 toward the center 320 of the entire photosensor arrays.

Fig. 29 shows the photosensor arrays inversely projected onto a plane at a predetermined distance at the object side. Also on the object side, the inversely projected images of the pixels in the photosensor arrays 321, 324 are represented by white rectangles 371, while those of the pixels in the photosensor array 322 are represented by hatched rectangles 372, and those of the pixels in the photosensor array 323 are represented by black rectangles 373.

The inversely projected images of the centers 361, 362, 363, 364 of the object images mutually coincide at a point 360, and the pixels of the photosensor arrays 321, 322, 323, 324 are inversely projected in such a manner that the centers thereof do not mutually overlap. Since the white rectangles output the G image signal while the hatched rectangles output the R image signal and the black rectangles output the B image signal, so that, on the object, there is executed sampling equivalent to that in an image pickup element having the color filters of Bayer arrangement.

In the comparison with an image pickup system utilizing a single image pickup lens, for a given pixel pitch in the solid-state image pickup element, the system of the present embodiment provides an object image of a size of 1/√4 in comparison with the Bayer arrangement having the RGBG color filters for a set of 2 × 2 pixels on the semiconductor chip 503. Accordingly, the focal length of the image pickup lens is reduced to about 1/√4 = 1/2, thus extremely advantageous for reducing the camera thickness.

In the following there will be explained the method for producing the image pickup module of the present embodiment. The optical element and the semiconductor chip are adjoined in a stage of the stereoscopic optical element assembly and the semiconductor wafer prior to the cutting, and a spacer assembly is provided between the stereoscopic optical element assembly and the semiconductor wafer.

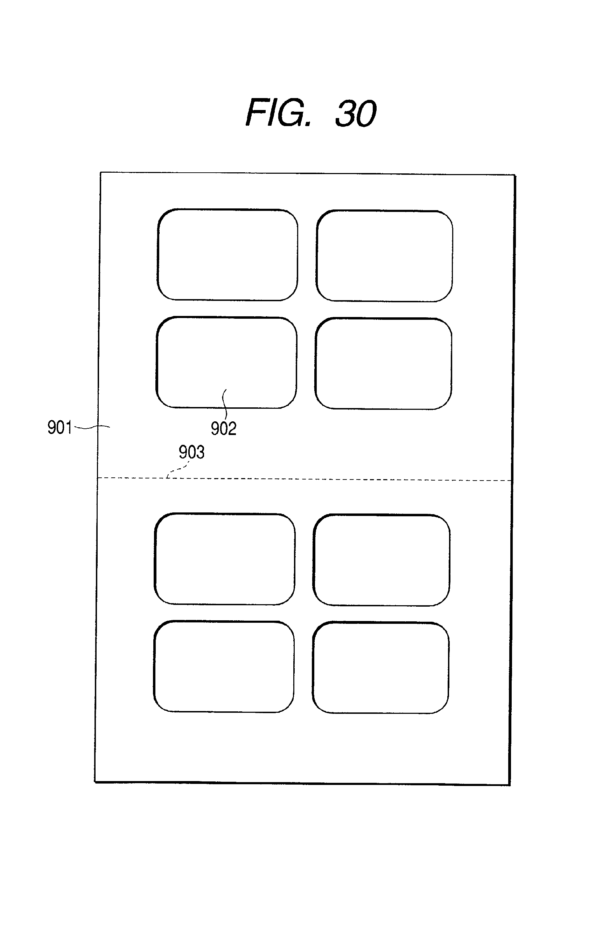

Fig. 30 is a plan view of an assembly of the spacer to be mounted in the image pickup module of the embodiment 5 of the present invention. Fig. 30 shows a spacer assembly 901 which is to be later divided along a division line 903 for use in two image pickup modules and which is provided with plural apertures 902 for guiding the light beams from the optical element to the photosensors on the semiconductor chip. An optical element assembly to be adhered and fixed on the spacer assembly 901 also integrally includes optical components for two image pickup modules as will be explained later. The pitch of these components is same as the pitch of the semiconductor chips formed on the semiconductor wafer to be explained in the following. The spacer 522 and the semiconductor chip 503 are adhered by thermosetting resin. A pattern 509 shown in Fig. 26C is formed by screen printing such thermosetting epoxy resin.

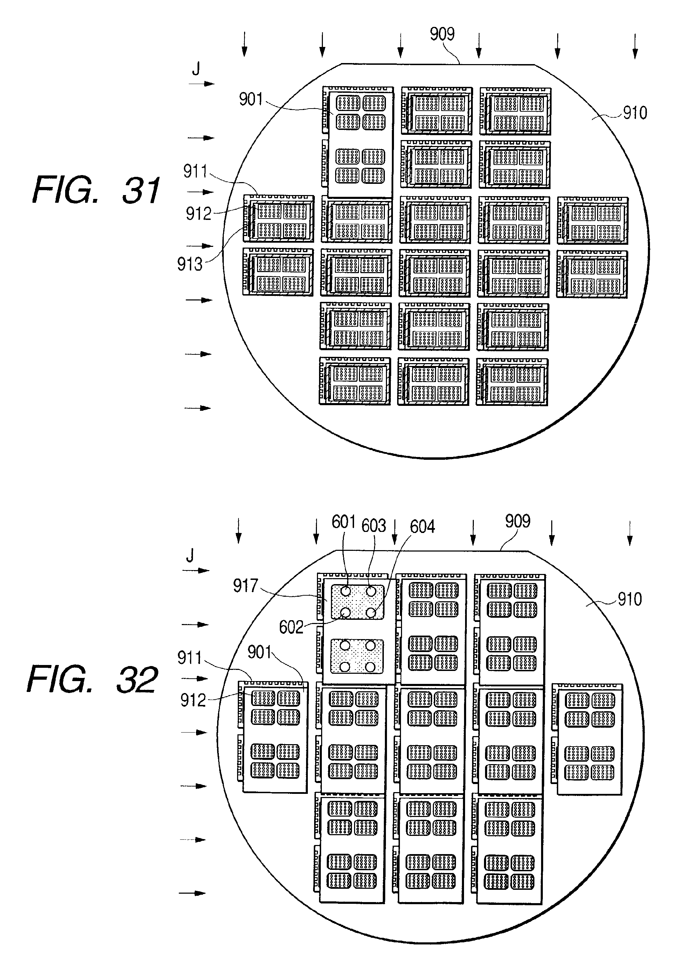

Fig. 31 is a plan view of a semiconductor wafer in the manufacturing process for the image pickup module of the present invention, wherein a semiconductor wafer 910 bearing the photosensor array 912 and an electrical circuit in plural units is separated by cutting along the outer periphery of the boundary line 911, and each cut piece functions as the semiconductor chip upon being connected with the external electrical circuit. Arrows J indicate the position and moving direction of the dicing blade in a later dicing step.

The spacer assembly 901 is adhered to the semiconductor wafer 910 by thermosetting resin 931 (corresponding to the sealant 509 in Fig. 26C) as explained in the foregoing. Fig. 31 illustrates only one spacer assembly 901.

Fig. 32 is a plan view showing a step of adhering the spacer assembly to the semiconductor wafer in the manufacturing process for the image pickup module of the embodiment 5 of the present invention. Since the spacer does not require precise positional adjustment as in the optical element, it is also possible to individually provide each semiconductor chip with a spacer instead of utilizing a spacer assembly.

When the spacer assembly 901 is adhered onto the semiconductor wafer 910 as shown in Fig. 32, the optical element assembly 917 is further adhered thereon. In this operation, the convex lenses 601, 602, 603, 604 and the photosensor arrays 912 are aligned in a predetermined positional relationship, and in such a manner that the boundary line 911 of the semiconductor chip 912 and the optical element assembly 917 are shifted in the diagonal direction. Such arrangement enables connection of the surface electrode to the external electrical circuit with the bonding wire. Fig. 32 illustrates an optical element assembly 917 only.

The semiconductor wafer, being crystalline, generally has anisotropy in electrical, optical, mechanical and chemical properties. Therefore the drawn ingot is sliced after highly precise measurement of the orientation by a method utilizing X-ray diffraction. Prior to the slicing operation, a linear portion, called orientation flat and indicating the crystalline orientation, is formed on the cylindrical ingot. The semiconductor wafer 910 shown in Fig. 31 is provided with such orientation flat 909.

In the preparation step of the semiconductor wafer 910, the semiconductor element patterns such as the photosensor array 912 are formed with reference to the orientation flat 909. On the other hand, on the optical element assembly 917, a reference pattern is formed also on the stereoscopic optical element assembly 917 and is used for the alignment with the orientation flat 109, thereby enabling extremely precise alignment. Besides, such method provides an extremely important advantage that a single alignment of the stereoscopic optical element assembly 917 and the semiconductor wafer 910 completes the alignment on all the image pickup modules to be formed by the cutting in a later step.

The adhesive (sealant) 509 shown in Fig. 26B and composed of thermal/ultraviolet settable epoxy resin is used for adhering the stereoscopic optical element assembly 917. Epoxy resin is suitable for this application because it shows slow hardening without unevenness in the contraction at the hardening and shows relaxation of the stress. Though there is known epoxy resin settable by heating, the epoxy resin of thermal/ultraviolet settable type is adopted because sufficient heating for hardening the thermally settable epoxy resin may deteriorate the microleses, replica portion or printed paint of the light shielding diaphragm layer 506 formed on the semiconductor wafer 910.

The adhesion step is executed, as shown in Fig. 32, by coating the epoxy resin (509 in Fig. 26B) on the plural spacer assemblies 901 adhered onto the semiconductor wafer 910, then half hardening the epoxy resin with ultraviolet irradiation, then executing pressing to form a predetermined gap, then executing complete hardening by applying some heat, and adjusting the gap between the optical element assembly 917 and the semiconductor wafer 910 in such a manner that the object image is sharply formed on the photosensor array 912.

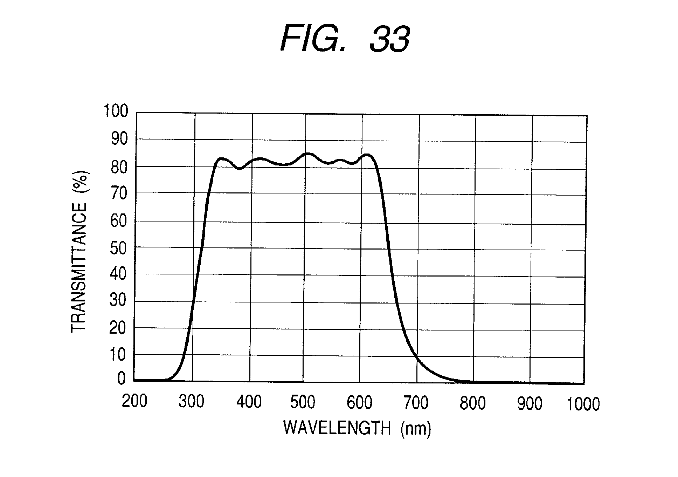

In such operation, by forming an infrared cut-off filter of spectral transmission characteristics capable of transmitting the ultraviolet light (of a wavelength region of about 300 to 700 nm) around the light shielding diaphragm layer 506 in the stereoscopic optical element 512 as shown in Fig. 33, the epoxy resin can be easily and securely hardened by the ultraviolet irradiation from the front side of the semiconductor wafer. The fixation by adhesion in the stage of the semiconductor wafer may also provide an effect of preventing a deviated blur in the optical image.

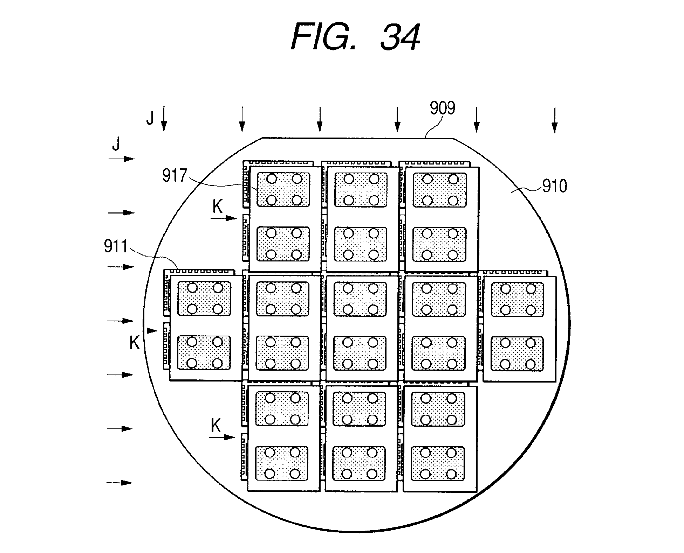

Fig. 34 is a plan view showing a step in which the stereoscopic optical element assembly, prior to the cutting thereof into the individual stereoscopic optical elements, and the semiconductor wafer are adhered in the manufacturing process of the image pickup module of the embodiment 5 of the present invention. The stereoscopic optical element assembly 917 is not provided with the optical elements of a number same as that of the semiconductor chips formed on the semiconductor wafer. The optical element assembly 917 shown in Fig. 34 is provided with two sets of convex lenses while the semiconductor wafer 910 is provided thereon with 11 stereoscopic optical element assemblies 917, and the succeeding dicing step cuts each into two stereoscopic optical elements to finally obtain 22 image pickup elements. Each stereoscopic optical element assembly is advantageously selected at a maximum size that can be accommodated within the effective exposure size of the stepper, thereby maximizing the number of the image pickup modules that can be produced from a wafer and thus reducing the cost.

By forming the stereoscopic optical elements on the stereoscopic optical element assembly 917 in a number smaller than that of the semiconductor chips formed on the semiconductor wafer 910 and forming a certain gap between the stereoscopic optical element assemblies, the positional relationship between the optical element and the semiconductor chip is scarcely deteriorated even in case the flatness of the semiconductor wafer, maintained highly precisely by suction of the rear surface to a jig, is worsened when the suction is terminated. Even in the recent trend of increase in the diameter of the semiconductor wafer, such configuration allows to easily obtain a high production yield.

After the fixation of the semiconductor wafer 910, the spacer assembly 901 and the stereoscopic optical element assembly 917, the obtained optical element-semiconductor wafer adjoined member is subjected to a dicing step for cutting such adjoined member into individual image pickup modules.

In the dicing step, there can be employed a cutting apparatus or a laser working apparatus disclosed in the Japanese Patent Application Laid-open No. 11-345785 or No. 2000-061677 as explained in the foregoing. In case of cutting operation with a dicing blade as explained in the Japanese Patent Application Laid-open No. 11-345785, the dicing blade is controlled along arrows J shown in Fig. 34, under cooling with cooling water, to cut the semiconductor wafer 910 only from the rear surface thereof.

Then the dicing blade is controlled along arrows K shown in Fig. 34 to cut the stereoscopic optical element only from the front surface of the stereoscopic optical element assembly. In such operation, there is utilized a dicing mark which can be a groove formed by etching on the metal element assembly 917, a metal mark formed by photolithography or a resinous protrusion formed by a replica process. In particular, the simultaneous replica formation of such mark with the lens constituting the imaging unit allows to reduce the manufacturing steps.

Since the adhesive layers for adhering the semiconductor wafer 910 and the spacer assembly 901 and adhering the spacer assembly 901 and the optical element assembly 917 are so formed as to exclude the dicing position, the epoxy resin is prevented from depositing on the lens surface by fusion by the friction with the dicing blade or by forming fine fragments or carbon particles, whereby the image pickup module can be prevented from deterioration in quality.

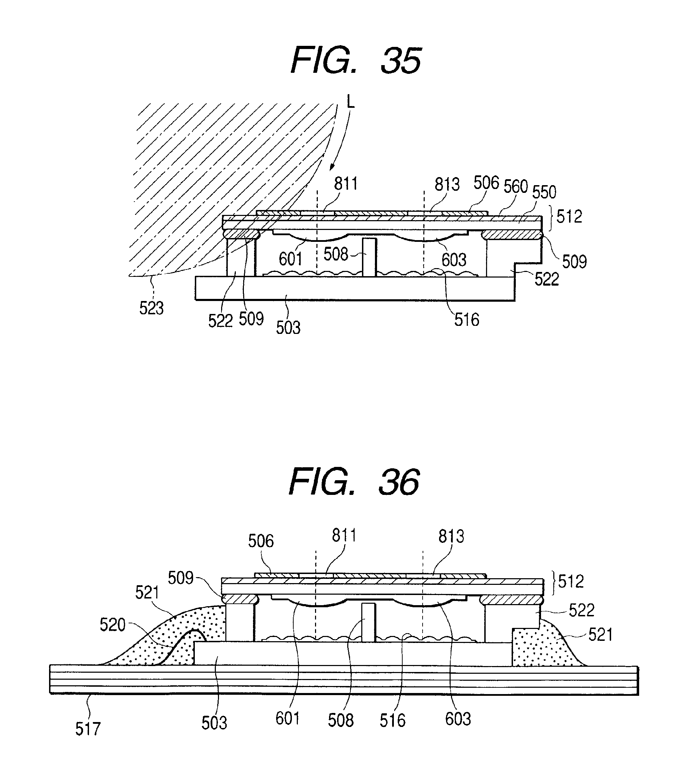

Fig. 35 is a schematic cross-sectional view showing a step of dicing the semiconductor wafer with the dicing blade, in the manufacturing process of the image pickup module of the embodiment 5 of the present invention. In this step, the dicing blade 523 rotates in such a direction L as to press the semiconductor wafer 910 prior to the separation into the respective semiconductor chips 503, but, if a resin layer connected to the convex lenses 601, 602, 603, 604 is present on the dicing lines, the dicing blade applies a force to such resin layer in such a direction as to peel it from the glass substrate of the stereoscopic optical element 512 thereby deteriorating the facial precision of the convex lenses 601, 602, 603, 604.

In the present embodiment, since the resin is excluded from the passing position of the dicing blade, the undesirable force is not applied to the convex lenses 601, 602, 603, 604 and such drawback is not generated. Also the resin is prevented from depositing on the lens surface by fusion by the friction with the dicing blade or by forming fine fragments or carbon particles, so that the image pickup module can be prevented from deterioration in quality.

Through the cutting in the aforementioned steps, there is obtained the image pickup module of the present invention shown in Figs. 26A and 26B.

Fig. 36 is a schematic cross-sectional view showing the connection state with the external electrical circuit and the sealing state of the image pickup module of the embodiment 5 of the present invention. In Fig. 36, there are shown a multi-layer printed circuit board 517 constituting an external electric circuit board, a bonding wire 520 for electrically connecting an unrepresented electrode pad 513 and an electrode pad on the multi-layer printed circuit board 517, and thermal/ultraviolet settable resin 521 for sealing the periphery of the electrode pad 513 and the bonding wire 520. The thermal-ultraviolet settable resin 520 is coated over the entire periphery of the image pickup module 511 for achieving mounting stability of the image pickup module to the multi-layer printed circuit board 517.

In the present embodiment, the sealing with the adhesive 509 and the separate thermal-ultraviolet settable resin 521 allows to securely prevent the deterioration of the microlenses 516 or the filter layer or the electroerosion of the aluminum layer resulting from the dust intrusion or the humidity in the air. Such sealing is even more effective since it can be achieved in the semiconductor preparing process. Also the electrical connection from the surface electrode to the external electrical circuit by the bonding wire enables manufacture at a low cost, without requiring an ITO film or a penetrating metal member. The configuration of the present embodiment is applicable also to the electrical connection not employing the bonding wire but utilizing a TAB film.

Also the present embodiment enables simultaneous alignment with the optical elements in the stage of the semiconductor wafer, without the active assembly of the imaging lens and the semiconductor chip for each image pickup module in the step of combining the imaging lens and the semiconductor chip, thereby allowing to significantly reduce the number of the adjusting steps.

### (Embodiment 6)

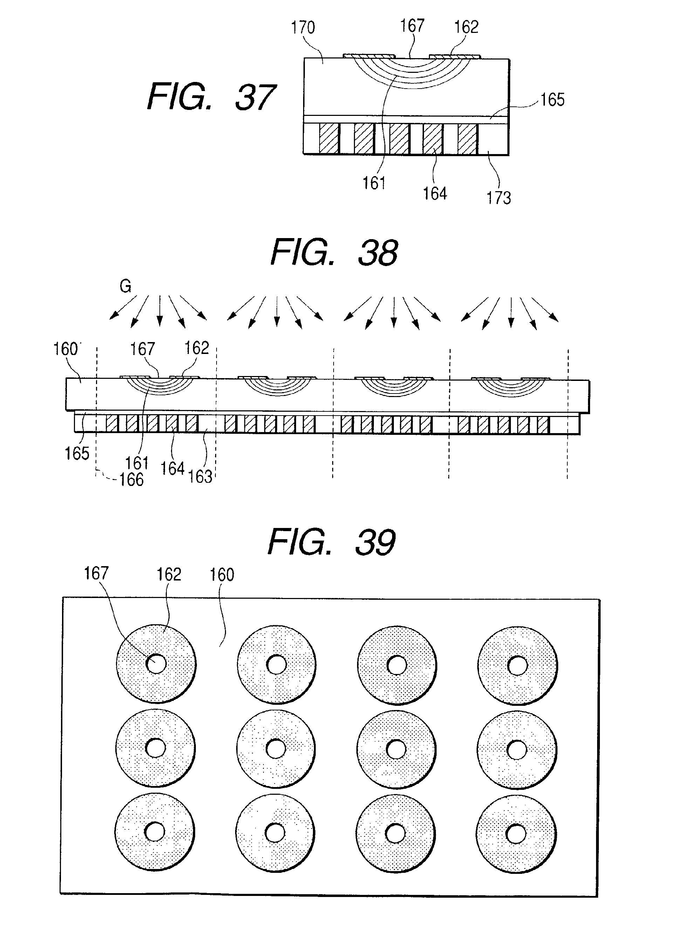

In the following there will be explained the image pickup module of an embodiment 6 of the present invention, with reference to Figs. 37 to 39. As in the embodiment 1, the optical element and the semiconductor chip are adjoined in the stage of the optical element assembly and the semiconductor wafer, prior to the separation into the respective optical element and the semiconductor chip. The optical element assembly is a single large-sized translucent plate-shaped member.

Fig. 37 is a schematic cross-sectional view of the image pickup module of the embodiment 6 of the present invention, Fig. 38 is a schematic cross-sectional view showing an ultraviolet irradiation step to the optical element-semiconductor wafer adjoined member in the manufacturing process of the image pickup module of the embodiment 6, and Fig. 39 is a plan view of the optical element assembly constituting the image pickup module of the embodiment 6.

In Fig. 37, there are shown an adhesive layer 165, a distributed refractive index lens 161 constituting the imaging unit, a circular light shielding diaphragm layer 162 formed by offset printing of light shielding paint on the upper face of the optical element assembly 160, and a diaphragm aperture 167 formed in the light shielding diaphragm layer 162. The semiconductor wafer 163 is provided with the electrical circuit and the photosensor array in plural units and is to be cut off in a later step into the respective semiconductor chips 173. The distributed refractive index lenses 161 have such an optical path length as to form object images on the semiconductor wafer 163, and have a pitch equal to that of the semiconductor chips formed on the semiconductor wafer.

Components equivalent to those explained in the foregoing are represented by like numbers and will not be explained further.

In the present embodiment, as shown in Fig. 39, a circular light shielding diaphragm layer 162 is formed by printing light shielding paint for example by offset printing on the upper face of the optical element assembly 160. Since the adhesive 165 of the present embodiment is composed of ultraviolet settable resin, the light shielding layer 162 is limited in an island-shape in order to enable ultraviolet irradiation of the adhesive 165 from the front side of the image pickup module. In case the adhesive 165 is composed for example of a sheet member or thermosetting resin and does not require ultraviolet irradiation, the light shielding diaphragm layer need not be limited in such island shape.

The present embodiment is different from the embodiment 5 in that the imaging unit is composed of a distributed refractive index lens integral with the optical element of the image pickup module. The distributed refractive index lens is a lens having axially symmetrical distribution of refractive index and showing a higher refractive index closer to the diaphragm aperture 167, and can be regarded equivalent to a planoconvex lens. Such lens can be produced by ion exchanging of glass or by impregnation of a resin layer with resin of different refractive index as disclosed in the Japanese Patent Application Laid-open No. 11-142611. The optical element, assembly 160 is preferably composed of borosilicate glass in consideration of stability against temperature change, because of a small difference in the linear dilatation coefficient from the semiconductor wafer. Also in order to prevent the α-ray induced defect in the semiconductor wafer, there is preferably employed optical glass of a low surfacial α-ray density. Also in order to attain infrared cut-off function, an infrared absorbing element such as copper ions may be contained in the constituting materials.

The position of the diaphragm aperture 167 in the axial direction determines the off-axis principal ray of the optical system and is extremely important in controlling various aberrations. In case of a lens including a distributed refractive index layer convex to the object side, the aberrations can be satisfactorily corrected by placing the diaphragm at the side of the light entrance face. Thus, a circular diaphragm aperture 167 coaxial with the distributed refractive index lens 161 is formed by the light shielding layer 162 on the optical element assembly 160.

The principal steps for completing the image pickup module are, as in the foregoing embodiments, a step of alignment and adhesion of the semiconductor wafer 163 and the optical element assembly 160, and dicing and breaking steps.

In the alignment-adhesion step, at first the space between the semiconductor wafer 163 and the optical element assembly 160 is filled by the adhesive layer 165 of the thermal-ultraviolet settable epoxy resin without forming an air layer therein to set the gap between the optical element assembly 160 and the semiconductor wafer 163 in such a manner that the object image can be sharply formed. Though there is known adhesive of a type settable by heating, the adhesive of thermal/ultraviolet settable type is selected because sufficient heating for hardening the thermally settable epoxy resin may deteriorate the unrepresented color filters, replica portion or printed paint of the light shielding diaphragm layer 162, formed on the semiconductor wafer 163.

Then diffuse ultraviolet irradiation is executed as indicated by an arrow G in Fig. 38 to harden the epoxy resin of the adhesive layer 165, thereby fixing the semiconductor wafer 163 and the optical element assembly 160. In this operation, the ultraviolet light reaches the adhesive layer 165 through the transparent area (non-printed area of the light shielding layer 162 in the optical element) of the optical element assembly 160. Besides, since there is employed diffuse irradiation, the ultraviolet light also reaches the adhesive layer 165 positioned below the light shielding diaphragm layer 162 whereby the entire adhesive layer 165 can be hardened sufficiently.

In a succeeding dicing step, half-cut dicing is executed along the boundary lines 166 shown in Fig. 38. In a breaking step succeeding to the dicing step, the uncut portion of 50 to 100 µm in the semiconductor wafer 163 or the optical element assembly 160 is broken with predetermined rollers. Thereafter each cut piece can function as the image pickup module by connection to the external electrical circuit.

Such sealing with the adhesive 165 allows to prevent deterioration of the filter layer or electroerosion of the aluminum layer resulting from dust intrusion or humidity in the air. Such sealing is even more effective since it is executed in the semiconductor manufacturing process. Also the number of the adjusting steps can be significantly reduced since the alignment with the optical elements can be achieved at a time in the stage of the semiconductor wafer.

### (Embodiment 7)

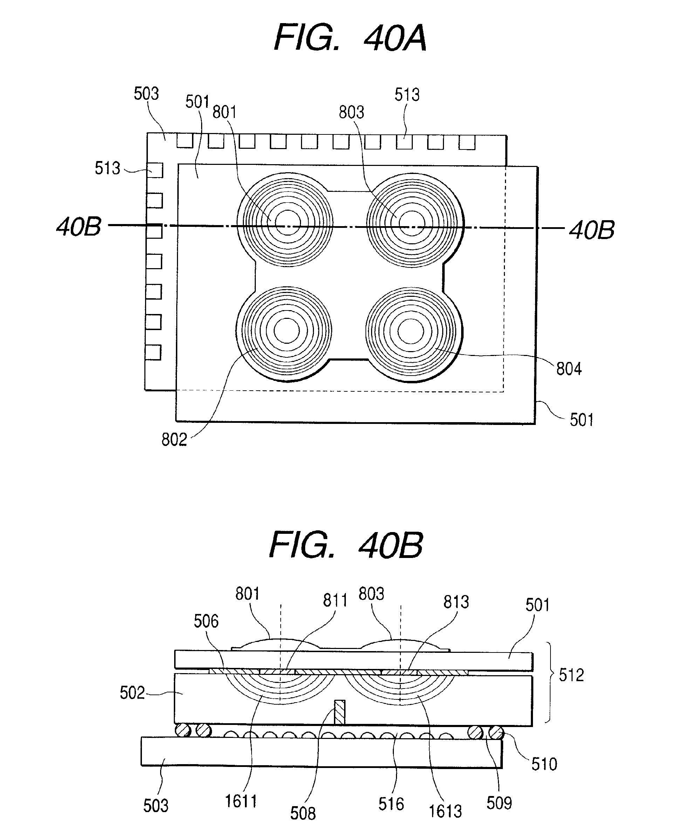

Figs. 40A and 40B to 46 illustrate a stereoscopic image pickup module of an embodiment 7, applicable to a distance measuring apparatus or a color image pickup module.

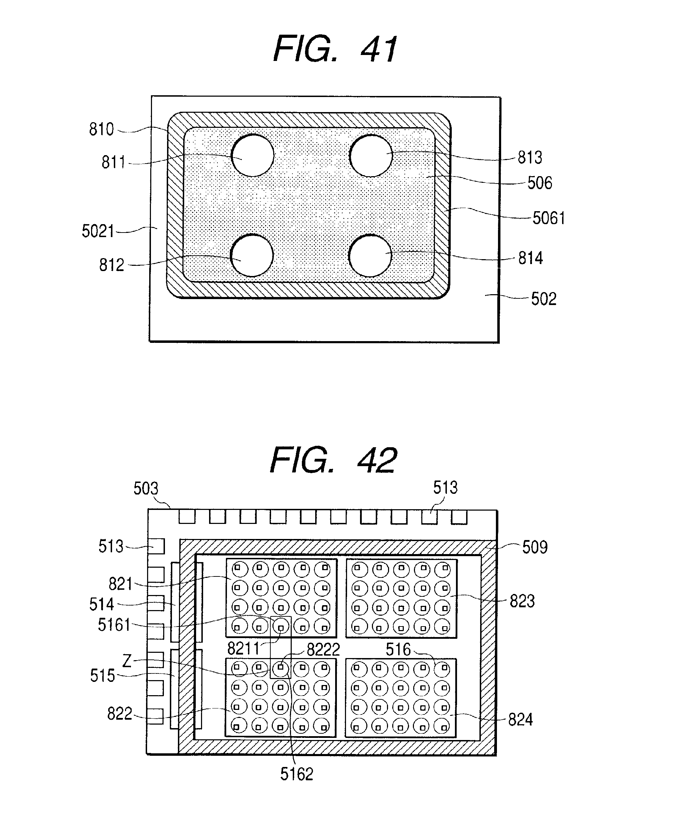

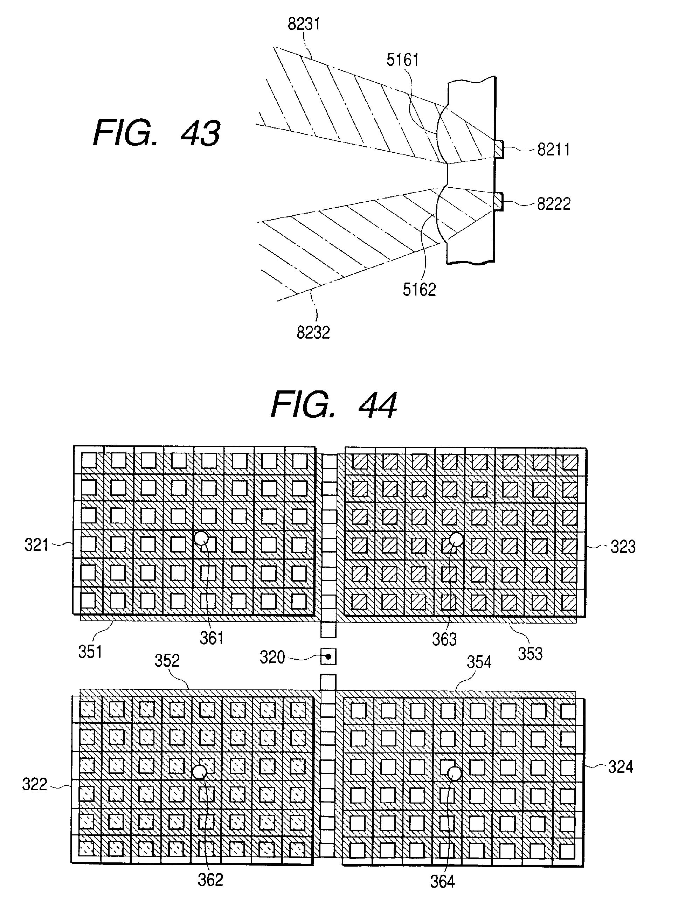

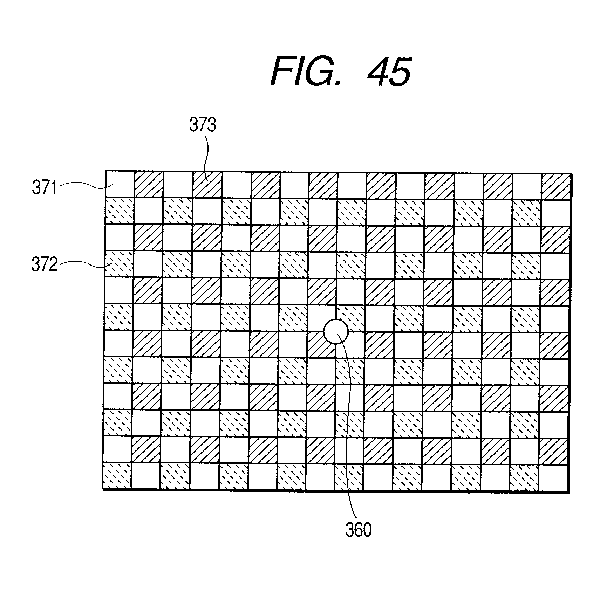

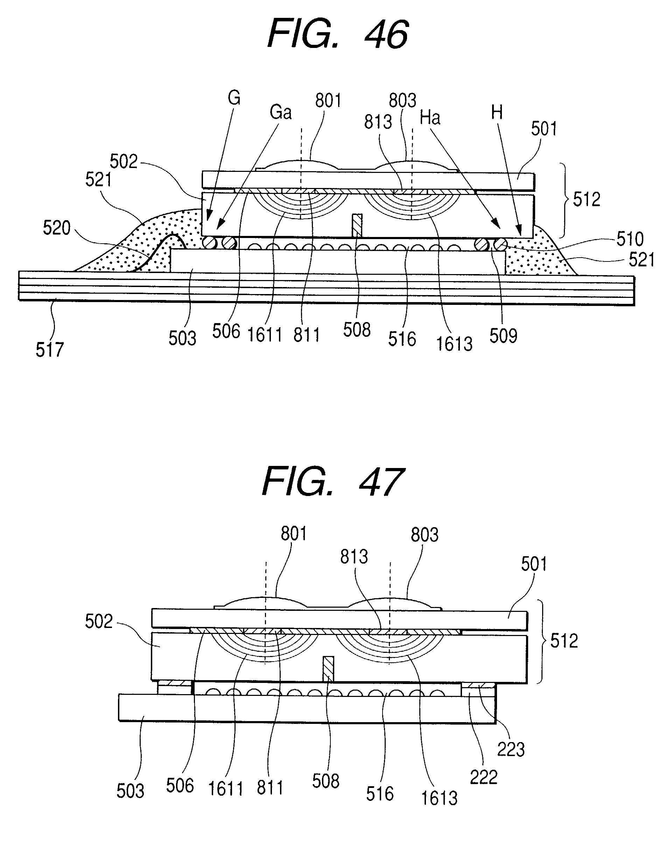

Fig. 40A is a plan view of the image pickup module of the embodiment 7 of the present invention; Fig. 40B is a schematic cross-sectional view along a line 40B-40B in Fig. 40A; Fig. 41 is a plan view of a lower substrate of the image pickup module of the embodiment 7; Fig. 42 is a plan view of a semiconductor chip of the image pickup module of the embodiment 7; Fig. 43 is a magnified schematic cross-sectional view of a region z in Fig. 42 for showing the function of the microlenses in the image pickup module of the embodiment 7; Fig. 44 is a view showing the positional relationship between the photosensor array of the semiconductor chip and the object image in the image pickup module of the embodiment 7; Fig. 45 is a view showing the function of the photosensor array in the image pickup module of the embodiment 7; and Fig. 46 is a schematic cross-sectional view showing the connection with the external electrical circuit and the sealing state of the image pickup module of the embodiment 7.

In Figs. 40A and 40B, there are shown an upper substrate 501 of the optical element 512, a lower substrate 502 thereof, a distributed refractive index lens 1611 constituting a second lens formed on the lower substrate 502 for the light passing through a diaphragm aperture 811, a distributed refractive index lens 1613 constituting a second lens formed on the lower substrate 502 for the light passing through a diaphragm aperture 813, a bead 510 for defining the thickness of the adhesive 509, and an optical element 512 constituted by the upper substrate 501 and the lower substrate 502.

Components equivalent to those explained in the foregoing are represented by like numbers and will not be explained further.

The present embodiment is different from the embodiment 5 in that the components constituting the optical element 512 include the upper substrate in which convex lenses 801, 802, 803, 804 are formed as the first lenses and the lower substrate 502 in which distributed refractive index lenses 1611, 1613 are formed. There are shown diaphragm apertures 811, 813. Though not illustrated, diaphragm apertures 812, 184 are naturally present respectively under the convex lenses 802, 804.

Therefore, the image pickup module of the present embodiment includes a first stereoscopic lens formed by plural first lenses, and a second stereoscopic lens formed by plural second lenses.

In the present embodiment, the second lenses are composed of distributed refractive index lenses, but they may also be composed of ordinary spherical or aspherical lenses as in the first lenses.

The object light entering the optical element 512 from above in Fig. 40B forms plural object images on the semiconductor chip 503, and is subjected to photoelectric conversion by the photosensors therein.

The upper substrate 401 is formed by adding, to a flat glass substrate, a resinous Fresnel lens formed by replica process. The distance between the lens and the photosensor array on the semiconductor chip is rendered dependent on the thickness of the replica layer, and the error in the thickness of the upper and lower substrate glasses is absorbed by the thickness in the replica layer. It is also possible to form the lens portion integrally with the substrate for example by glass molding in case the lens is composed of glass, or by injection molding or compression molding in case the lens is composed of resin.

The first lenses 801, 802, 803, 804 are axially symmetrical circular aspherical or spherical Fresnel lenses as shown in Fig. 40A and capable of satisfactorily correcting in particular the curvature of the image plane in comparison with the ordinary optical system utilizing the continuous surface, but may also be composed of aspherical lenses formed by the replica process. Such lenses are inferior to the Fresnel lenses in the optical performance, but can be relatively easily produced and are more advantageous in cost.

On the other hand, the distributed refractive index lenses 1611, 1613 and the unrepresented ones 1612, 1614 are lenses having axially symmetrical distribution of refractive index and showing a higher refractive index closer to the diaphragm aperture to be explained later, and can be regarded equivalent to planoconvex lenses. Such lens can be produced by ion exchanging of glass or by impregnation of a resin layer with resin of different refractive index as disclosed in the Japanese Patent Application Laid-open No. 11-142611. The first lenses 801, 802, 803, 804 and the distributed refractive index lenses 1611, 1612, 1613, 1614 are coaxially adhered.

Since such distributed refractive index lens can increase the freedom of optical designing, there can be easily obtained optical performance superior to that of the optical system employing a single lens, and the optical image is not deteriorated even at a brighter F-number. Besides there can be obtained an optical system with a higher resolution limit frequency, because the resolution limit frequency, determined by the light diffraction, becomes higher in a brighter lens. Such configuration is therefore suitable for obtaining the image of a higher definition with the photosensor array of a smaller pixel pitch.

In the present embodiment, a circular light shielding diaphragm layer 506 is formed by printing light shielding paint for example by offset printing on the upper face of the lower substrate 502 of the optical element 512. In case the adhesive 165 is composed of a sheet member or thermosetting resin, the light shielding layer 506 need not be limited in an island-shape. In the present embodiment, since the adhesive 165 is composed of ultraviolet settable resin, the light shielding diaphragm layer 506 is limited in an island-shape. It is also possible to form a semi-transparent area 5061 around the light shielding diaphragm layer 506 to achieve securer hardening of the sealant as will be explained later.

The semi-transparent area 5061 can be formed for example by reducing the thickness of the printed film or by reducing the printed area ratio. It can also be formed by evaporating or sputtering a thin film of inconel, chromel or chromium. In the sputtering process, the transmittance can be arbitrarily controlled by continuous position control of a shield.

In adhering the upper substrate 501 and the lower substrate 502 with translucent adhesive, the adhesion is so executed as not form a gap, thus avoiding formation of an interface between the air and the substrate, thereby advantageously preventing ghost image formation. The light shielding diaphragm layer 506 may also be formed by offset printing light shielding paint on the lower face of the upper substrate 501.

The position of the diaphragm apertures 811, 812, 813, 814 in the axial direction determines the off-axis principal ray of the optical system and is extremely important in controlling various aberrations. In the imaging unit including a Fresnel surface convex to the object side and a distributed refractive index lens convex to the image side, the aberrations can be satisfactorily corrected by placing the diaphragm in the interior of the imaging unit. Thus, as shown in Fig. 40B, four circular diaphragm aperture 811, 812, 813, 814 are formed by the light shielding layer 506 of the lower substrate 502.

Also, inside the diaphragm apertures 811, 812, 813, 184 there are formed, by screen printing, color filters for transmitting the light of a specified wavelength region only. Green transmitting (G) filters are provided in the diaphragm apertures 811, 814, while a red transmitting (R) filter is provided in the diaphragm aperture 812, and a blue transmitting (B) filter is provided in the diaphragm aperture 813. Since a thin transparent adhesive layer is present between the color filter and the upper substrate 501, the flatness of the filter is not important even though it is positioned at the plane of the diaphragm, so that the filter can be formed by printing.

The combined optical performance of the lenses 801, 802, 803, 804, the diaphragm apertures 811, 812, 813, 814 and the distributed refractive index lenses 1611, 1612, 1613, 1614 is optimized for each color of the color filters. More specifically, the shapes of the lenses 801, 802, 803, 804 and the diameters of the diaphragm apertures 811, 812, 813, 814 are made slightly different depending on the colors of the color filters, namely on the transmission wavelengths thereof, while the distributed refractive index lenses 1611, 1612, 1613, 1614 have a same distribution of the refractive index. The difference in the shapes of the lenses 801, 802, 803, 804 and in the diameters of the diaphragm apertures 811, 812, 813, 814 are in fact so slight that they are not illustrated in the drawing of the present specification.

Also the optical performance to be optimized for the respective colors of the color filters is only assigned to the lenses (prepared by molding) and the diaphragm apertures (prepared by printing) which can be produced with relatively high precision while the optical performance is maintained same for all the distributed refractive index lenses, so that the yield can be improved in the manufacture of the image pickup module.

Such optimization of the optical performance of the image pickup optical system for the respective colors of the color filters is intended to generate the Bayer arrangement image at a high precision by the pixel displacement technology to be explained later, and the details of such technology is disclosed in an image pickup apparatus described in the Japanese Patent Application Laid-open No. 2001-78123.

It is formed by filling a groove, formed by half-cut dicing of the lower substrate 502, with black resin. Also in order to achieve infrared cut-off function, an infrared-absorbing element such as copper ions is included in the material constituting the upper and/or lower substrate 501, 502.

On the semiconductor chip 503, as shown in Fig. 42, the optical element 512 forms four object images of RGBG colors, which are subjected to photoelectric conversion by the photosensor arrays 821, 822, 823, 824 provided on the semiconductor chip and are captured as electrical signals. Each of the photosensor arrays 821, 822, 823, 824 shown in Fig. 42 is composed of a two-dimensional array of multiple pixels. Each photosensor in the photosensor arrays 821, 822, 823, 824 is provided with a microlens 516 for improving the light condensing efficiency.

Also the microlenses 516 are eccentrically positioned with respect to the photosensors of the semiconductor chip 503, and the amount of such eccentricity is zero at the center of each of the photosensor arrays 821, 822, 823, 824 but becomes larger toward the peripheral portion thereof. The direction of eccentricity is along a line connecting the center of each photosensor array and each phtosensor.

Fig. 43 is a magnified schematic cross-sectional view of a region Z in Fig. 42, for explaining the function resulting from the eccentric positioning of the microlens 516. A microlens 5161 is eccentrically positioned in the upper direction in the direction with respect to a photosensor 8211, while a microlens 5162 is eccentrically positioned in the lower direction with respect to a photosensor 8222. As a result, the light beam entering the photosensor 8211 is limited to a hatched area 8231, while the light beam entering thephotosensor 8222 is limited to a hatched area 8232.

The light beam areas 8231, 8232 are inclined in respectively opposite directions, and are respectively directed toward the diaphragm apertures 811, 812. Consequently, by suitably selecting the amount of eccentricity of the microlenses 516, each photosensor array only receives the light beam emerging from a specified diaphragm aperture. More specifically, the amount of eccentricity can be so selected that the object light passing through the diaphragm aperture 811 is photoelectrically converted principally in the photosensor array 821, the object light passing through the diaphragm aperture 812 is photoelectrically converted principally in the photosensor array 822, the object light passing through the diaphragm aperture 813 is photoelectrically converted principally in the photosensor array 823 and the object light passing through the diaphragm aperture 814 is photoelectrically converted principally in the photosensor array 824.

In the following there will be explained the positional relationship between the object image and the image pickup area and the positional relationship of the pixels when projected onto the object. Figs. 44 and 45 are views showing such positional relationships. In Fig. 44, there are shown four photosensor arrays 321, 322, 323, 324 of the semiconductor chip 503. For the purpose of simplicity, each of the photosensor arrays 321, 322, 323, 324 is assumed to be composed of 8 × 6 pixels. The photosensor arrays 321, 324 output the G image signal, while the photosensor array 322 outputs the R image signal, and the photosensor array 323 outputs the B image signal. The pixels in the photosensor arrays 321, 324 are indicated by white rectangles, while those in the photosensor array 322 are represented by hatched rectangules, and those in the photosensor array 323 are indicated by black rectangles.

Between the photosensor arrays, there are formed separating belts of a dimension of a pixel in the horizontal direction and three pixels in the vertical direction. Consequently, the distance between the centers of the photosensor arrays outputting the G images is same in the horizontal and vertical directions. There are also shown object images 351, 352, 353, 354. For the purpose of pixel displacement, the centers 361, 362, 363, 364 of the object images 351, 352, 353, 354 are respectively offset by 1/4 of a pixel from the centeres of the photosensor arrays 321, 322, 323, 324 toward the center 320 of the entire photosensor arrays.

Fig. 45 shows the photosensor arrays inversely projected onto a plane at a predetermined distance at the object side. Also on the object side, the inversely projected images of the pixels in the photosensor arrays 321, 324 are represented by white rectangles 371, while those of the pixels in the photosensor array 322 are represented by hatched rectangles 372, and those of the pixels in the photosensor array 323 are represented by black rectangles 373.

The inversely projected images of the centers 361, 362, 363, 364 of the object images mutually coincide at a point 360, and the pixels of the photosensor arrays 321, 322, 323, 324 are inversely projected in such a manner that the centers thereof do not mutually overlap. Since the white rectangles output the G image signal while the hatched rectangles output the R image signal and the black rectangles output the B image signal, so that, on the object, there is executed sampling equivalent to that in an image pickup element having the color filters of Bayer arrangement.

In the comparison with an image pickup system utilizing a single image pickup lens, for a given pixel pitch in the solid-state image pickup element, the system of the present embodiment provides an object image of a size of 1/√4 in comparison with the Bayer arrangement having the RGBG color filters for a set of 2 × 2 pixels on the semiconductor chip 503. Accordingly, the focal length of the image pickup lens is reduced to about 1/√4 = 1/2, thus extremely advantageous for reducing the camera thickness.

Now again referring to the configuration of the image pickup module, the optical element 512 and the semiconductor chip 503 are adhered with thermal/ultraviolet settable resin. In Fig. 42, a sealant pattern 509 is formed by screen printing of thermal-ultraviolet settable epoxy resin. In the sealant there are dispersed beads 510 of a diameter for example of 6 µm to exactly define the thickness of the adhesive 509 constituting the gap between the optical element 512 and the semiconductor chip 503, whereby the object images can be sharply focused on the photosensor arrays 821, 822, 823, 824. Since such gap can be strictly controlled, the microlens 516 can be prevented from contacting the lower substrate 502 and can improve the light condensing efficiency, thereby providing an image pickup module capable of easily taking the image of even an object of low luminance.

The beads 510 may be composed of organic polymer or quartz, but quartz beads may damage the protective film, electrode or switching element formed on the semiconductor wafer in the pressing step for gap defining, and the organic polymer beads are preferred because the pressurizing condition can be selected in a wider range in the pressing step.

Fig. 47 is a schematic cross-sectional view showing another configuration of the image pickup module of the embodiment 7 of the present invention. In the image pickup module shown in Fig. 47, a spacer 222 is formed under the sealant, and a sealant 223 without the beads is formed thin thereon to define the gap between the optical element 512 and the semiconductor wafer 503. In such case, the spacer 222 may be composed of a material same as that of the microlens and may be formed at the same time in the microlens forming step.

Also the sealant may be positioned on the circuit of the semiconductor chip 503 as shown in Fig. 42, either by not employing the beads, or by employing organic polymer beads 510, or optimizing the pressurizing condition in the pressing step for the quartz beads.

By superposing the circuit portion and the seal portion on the semiconductor chip, the chip area can be reduced to provide an advantage in cost.

The epoxy resin is suitable for this application because it shows slow hardening without unevenness in the contraction at the hardening and shows relaxation of the stress. Though there is known adhesive of a type settable by heating, the adhesive of thermal-ultraviolet settable type is selected because sufficient heating for hardening the thermally settable epoxy resin may deteriorate the microlenses 516, printed paint of the light shielding diaphragm layer 506 or color filters formed on the semiconductor chip 503.

The adhering step is executed by superposing the optical element 512 on the semiconductor chip 503 with a shift in the diagonal direction, then half-hardening the epoxy resin constituting the adhesive 509 by ultraviolet irradiation, then executing pressing until a gap corresponding to the diameter of the beads 510 is formed, and completely hardening the epoxy resin by some heating.

In this operation, since the transparent area 5061 is formed around the light shielding layer 506 of the lower substrate 502 as explained in the foregoing, the epoxy resin constituting the adhesive 509 can be easily and securely hardened by the ultraviolet irradiation from the front side of the semiconductor chip 503. The transparent area 5061 is only required to be transparent to the ultraviolet light and may be opaque to the light of other wavelengths.

Fig. 40A shows the image pickup module 211 obtained through the above-described steps, seen from the side of the principal plane of the upper substrate 501, wherein the semiconductor chip 503 is visible behind the upper substrate 501 and is provided on the two sides with electrode pads 513.

Fig. 46 is a schematic cross-sectional view showing the connection state with the external electric circuit and the sealing state of the image pickup module of the present embodiment. In the present embodiment, the electrode pad 513 formed on the semiconductor chip 503 and the electrode pad on the multi-layer printed circuit board 517 are connected by the bonding wire 520.

For hardening the thermal-ultraviolet settable resin 521, there is principally executed ultraviolet irradiation from the front side of the image pickup module. In order to avoid erosion of the electrode pads 132 of the semiconductor chip 503, the close contact between the lateral face of the lower substrate 502 and the thermal-ultraviolet settable resin 521 is extremely important.

In case the range of the light shielding diaphragm layer 506 is not limited to the interior of the adhesive 509, the ultraviolet light reaches the sealing portion of the lower substrate 502 through the layer of the thermal-ultraviolet settable resin 521, so that such portion hardens latest. In the present image pickup module, however, since the range of the light shielding diaphragm layer 506 is limited to the interior of the adhesive 509, there is secured an optical path for the ultraviolet light to the sealing portion of the lower substrate 502 as indicated by an arrow G and such optical path allows to achieve secure hardening and sealing of the thermal-ultraviolet settable resin 521 without going through the layer thereof. Also, since the semi-transparent area without the light shielding layer is present around the light shielding diaphragm layer 506, there also exists an optical path indicated by an arrow Ga, though lower in light intensity, to achieve securer hardening and sealing.

There also exist optical paths H and Ha to achieve high mounting stability to the multi-layer printed circuit board 517.

As explained in the foregoing, the sealing with the adhesive 509 and the thermal-ultraviolet settable resin 521 allows to securely prevent deterioration of the microlenses or the filter layer and electroerosion of the aluminum layer, resulting from the dust intrusion or by the humidity in the air. Also the semiconductor chip 503 can be sealed easily because of the use of the distributed refractive index lens of flat plate shape.

Also the electrical connection from the surface electrode to the external electrical circuit by the bonding wire enables manufacture at a low cost, without requiring an ITO film or a penetrating metal member. The configuration of the present embodiment is applicable also to the electrical connection not employing the bonding wire but utilizing a TAB film.

In the present embodiment, a case of taking the object image by separating into three colors of R, G and B and synthesizing a color image by an image pickup device in which the first stereoscopic lenses have three optical performances optimized for the respective colors while the second stereoscopic lenses have a same optical performance, but the present invention may also be applied to a known two-sensor image pickup device for taking the object image by separating into a luminance signal and two color signals or into a G signal and R, B signals and synthesizing a color image, wherein the image pickup module the first stereoscopic lenses have two optical performances optimized for the luminance signal and the color signals or for the G signal and the R, B signals while the second stereoscopic lenses have a same optical performance.

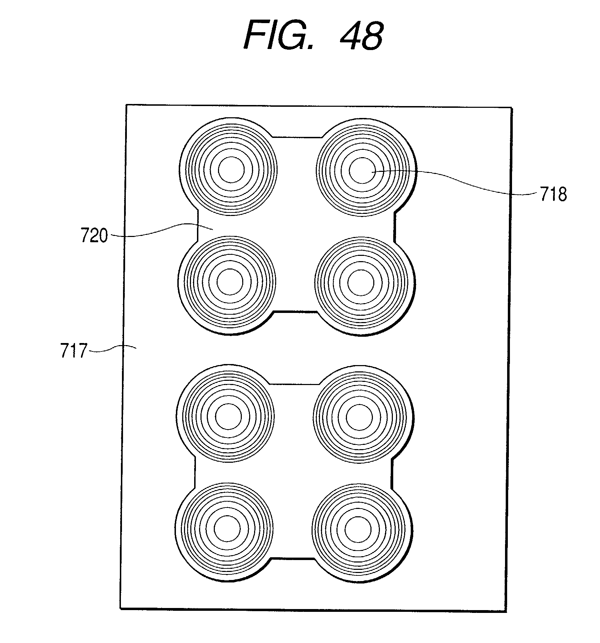

In the following there will be explained the method for producing the image pickup module of the present embodiment, with reference to Figs. 48 to 51. In the present embodiment, the optical element 512 and the semiconductor chip are adjoined in a stage of the optical element assembly and the semiconductor wafer prior to the cutting.

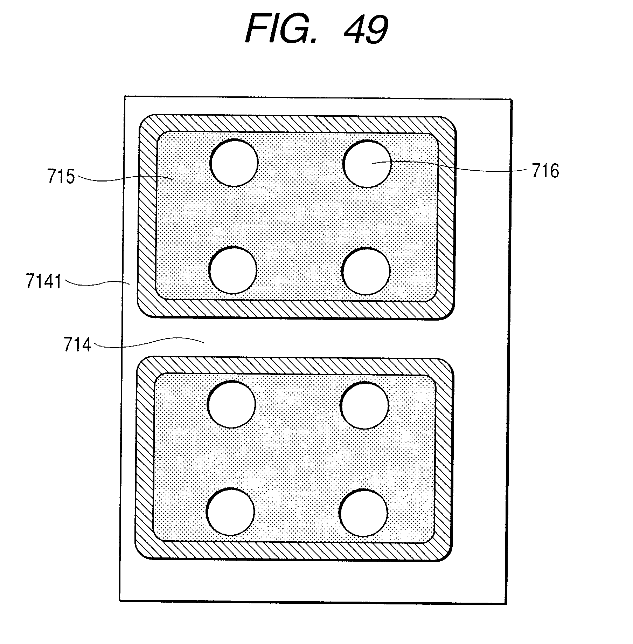

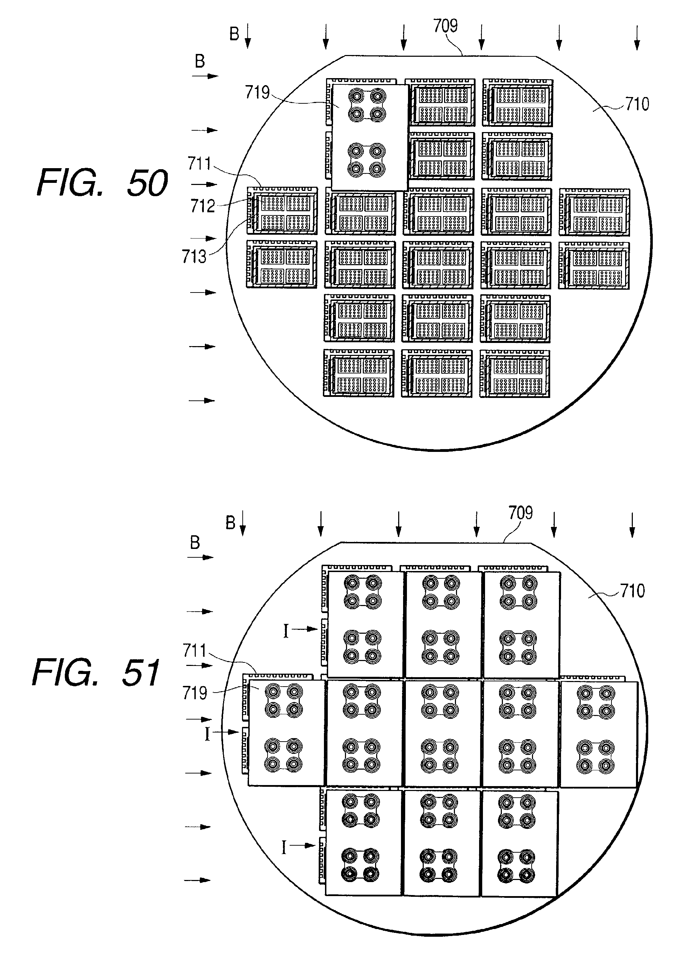

Fig. 48 is a plan view of an upper substrate assembly in the manufacturing process of the image pickup module of the embodiment 7 of the present invention, while Fig. 49 is a plan view of a lower substrate assembly in the manufacturing process of the image pickup module of the embodiment 7, and Fig. 50 is a plan view of a semiconductor wafer in the manufacturing process of the image pickup module of the embodiment 7. Fig. 51 is a plan view showing a step of separating the image pickup module from the optical element-semiconductor wafer adjoined member in the manufacturing process of the image pickup module of the embodiment 7.

In Fig. 48, there is shown an upper substrate assembly 717 of the optical element assembly, to be divided in a later step into two upper substrates 501 for two image pickup modules. In Fig. 49 there is shown a lower substrate assembly of the optical element assembly, and such upper substrate assembly 717 and the lower substrate assembly 714 are adjoined with translucent adhesive without forming a gap to obtain an optical element assembly of plate-shaped transparent member. The pitch of these components is same as the pitch of the semiconductor chips formed on the semiconductor wafer to be explained in the following.

On the semiconductor wafer 710 shown in Fig. 51, the photosensor array 912 and electrical circuits are formed in plural units by a known process and are separated by cutting along the outer periphery of the boundary line 911, and each cut piece functions as the semiconductor chip upon being connected with the external electrical circuit. In Fig. 51, arrows B indicate the position and moving direction of the dicing blade in a later dicing step. The semiconductor wafer 710 also bears ultraviolet settable epoxy resin constituting the adhesive 713 and formed by screen printing, and such epoxy is used for adhering the optical element assembly and the semiconductor wafer 710. Fig. 50 shows an optical element assembly 719 only.

Such configuration provides an extremely important advantage that a single alignment of the optical element assembly 719 and the semiconductor wafer 710 completes the alignment for all the image pickup modules to be formed by separation in a later step.

The adhesion step is executed, as shown in Fig. 50, by half hardening the epoxy resin, formed on the semiconductor wafer 710, with ultraviolet irradiation, then executing pressing to form a predetermined gap, then executing complete hardening by applying some heat, thereby adjusting the gap between the optical element assembly 719 and the semiconductor wafer 710 in such a manner that the object image is sharply formed on the photosensor array 712.

Fig. 51 shows a state upon completion of adhesion of all the optical element assemblies 719.

The optical element assembly 719 is not provided with the optical elements of a number same as that of the semiconductor chips 503 formed on the semiconductor wafer 710. The optical element assembly 719 shown in Fig. 51 is provided with two sets of convex lenses while the semiconductor wafer 710 is provided thereon with 11 optical element assemblies 719, and the succeeding dicing step cuts each into two optical elements to finally obtain 22 image pickup elements. Each optical element assembly 719 is advantageously selected at a maximum size that can be accommodated within the effective exposure size of the stepper, thereby maximizing the number of the image pickup modules that can be produced from a wafer and thus reducing the cost.

By forming the optical elements 512 on the optical element assembly 719 in a number smaller than that of the semiconductor chips formed on the semiconductor wafer 710 and forming a certain gap between the optical element assemblies, the positional relationship between the optical element and the semiconductor chip is scarcely deteriorated even in case the flatness of the semiconductor wafer, maintained highly precisely by suction of the rear surface to a jig, is worsened when the suction is terminated. Even in the recent trend of increase in the diameter of the semiconductor wafer, such configuration allows to easily obtain a high production yield. Also it is possible to employ a large-sized optical element assembly having the optical elements in a number same as that of all the semiconductor chips on the semiconductor wafer 710.

After the fixation of the semiconductor wafer 710 and the optical element assemblies 719, the obtained optical element-semiconductor wafer adjoined member is subjected to a dicing step for cutting such adjoined member into individual image pickup modules.

In the dicing step of a semiconductor wafer, a glass substrate or a resin substrate, there can be employed a cutting apparatus or a laser working apparatus disclosed in the Japanese Patent Application Laid-open No. 11-345785 or No. 2000-061677. In case of cutting operation with a dicing blade as in the former, the dicing blade is controlled along arrows B shown in Fig. 50, under cooling with cooling water, to cut the semiconductor wafer 710 only from the rear surface thereof.

Then the dicing blade is controlled along arrows I shown in Fig. 50 to cut the optical element only from the front surface of the optical element assembly 719.

In such operation, there is utilized a dicing mark which can be a groove formed by etching on the metal element assembly 917, a metal mark formed by photolithography or a resinous protrusion formed by a replica process. In particular, the simultaneous replica formation of such mark with the lens constituting the imaging unit allows to reduce the manufacturing steps.

Since the adhesive layer for adhering the semiconductor wafer 710 and the optical element assembly 719 are so formed as to exclude the dicing position, the epoxy resin is prevented from depositing on the lens surface by fusion by the friction with the dicing blade or by forming fine fragments or carbon particles, whereby the image pickup module can be prevented from deterioration in quality.

Also since the replica resin is excluded from the passing position of the dicing blade, such replica portion is maintained free of undesirable stress, thereby avoiding distortion or stress in the lenses. The separation in the above-described steps provides the image pickup module of the present embodiment as shown in Figs. 40A and 40B.

In the dicing step, since the dicing operations are executed in different phases from the top and rear sides, whereby the pads for the bonding wires can be exposed as shown in Fig. 40A to facilitate the later connection step with the electrical circuit.

Also the present embodiment enables simultaneous alignment with the optical elements in the stage of the semiconductor wafer, without the active assembly of the imaging lens and the semiconductor chip 503 for each image pickup module in the step of combining the imaging lenses 801, 8032, 803, 804 and the semiconductor chip 503, thereby advantageously allowing to significantly reduce the number of the adjusting steps.

### (Embodiment 8)

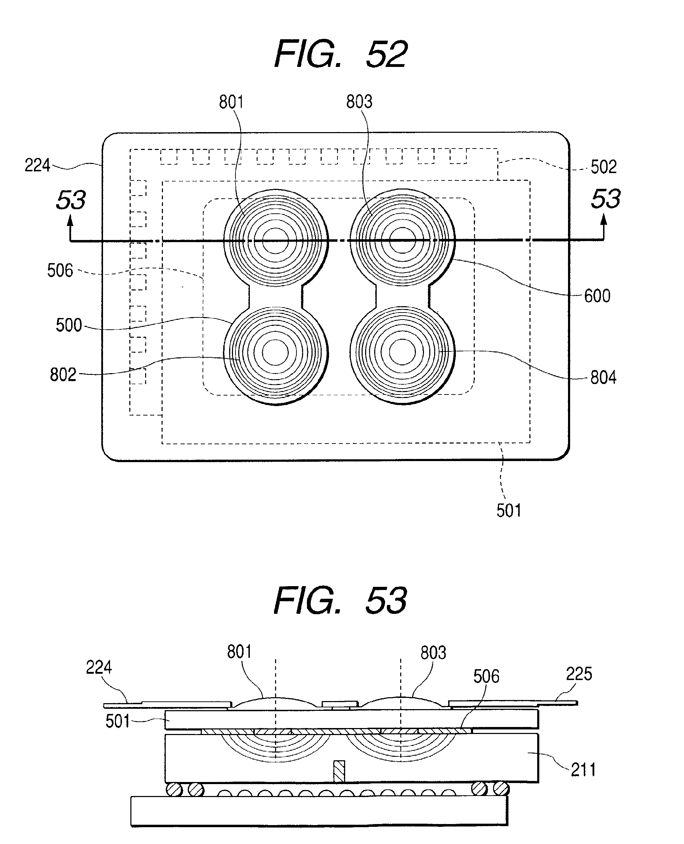

In this embodiment, there will be explained an image pickup module with improved light shielding property, with reference to Figs. 52 and 53.

Fig. 52 is a plan view of an image pickup module of the embodiment 8 of the present invention, and Fig. 53 is a schematic cross-sectional view along a line 53-53 in Fig. 52.

In Fig. 52, there is shown a light shielding plate 224 having sufficient light shielding property to the wavelength region received by the photosensor arrays.

Components equivalent to those explained in the foregoing are represented by like numbers and will not be explained further.

The present embodiment is different from the embodiment 7 in that the image pickup module is provided with the light shielding plate 224 for improving the light shielding property.

The light shielding plate 224 is fixed to the upper face of the image pickup module of the embodiment 7 as shown in Figs. 40A and 40B.

The light shielding plate 224 is provided with two apertures 500, 600, and two convex lenses 801, 802 are positioned in the aperture 500 while two convex lenses 803, 804 are positioned in the aperture 600. It is rendered possible to avoid stray light entering from the outside of the light shielding diaphragm layer 506, by shielding as far as possible the area other than the convex lenses 801, 802, 803, 804 on the upper substrate 501.

### (Embodiment 9)

In the present embodiment there will be explained an image pickup device utilizing the image pickup module of the foregoing embodiments 1 to 8.

The image pickup device of the present embodiment is featured by a reduced thickness realized by employing the stereoscopic optical elements explained in the embodiment 7.

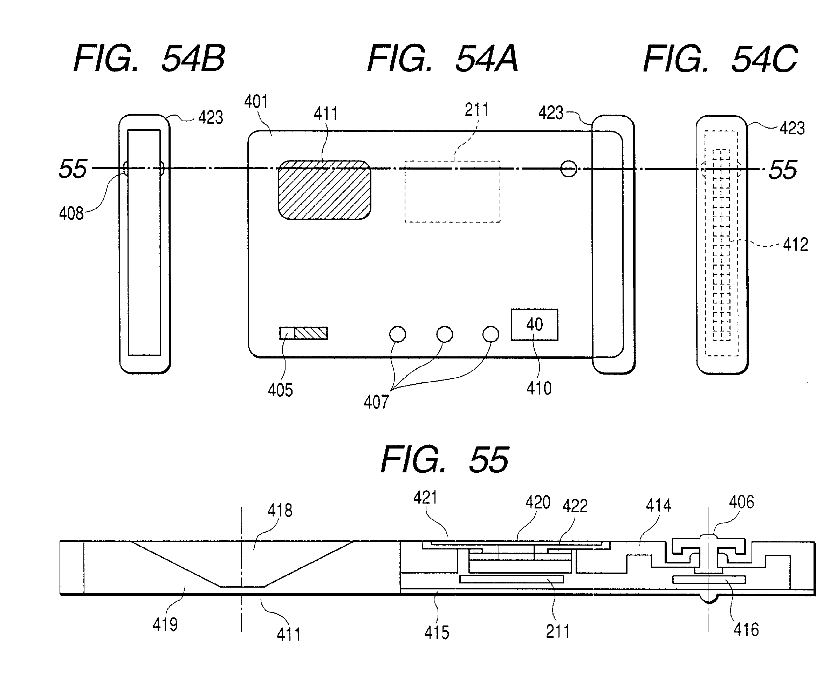

Figs. 54A, 54B and 54C are entire views of a digital color camera equipped with the image pickup module of the present invention, wherein Fig. 54A is a rear side view, Fig. 54B is a lateral view seen from the left-hand side in Fig. 54A, and Fig. 54C is a lateral view seen from the right-hand side in Fig. 54A. Fig. 55 is a schematic cross-sectional view along a line 55-55 in Fig. 54A. In the present embodiment there will be explained a digital color camera utilizing color filters, but the present invention is naturally applicable also to a digital camera not provided with the color filters.

Referring to Fig. 54A to 54C, there are shown a main body 401 of the camera of card shape, a main switch 405, a release button 406, a switch 407 for setting the camera status by the user, a display unit 410 for indicating the remaining number of the image pickup frames, an eyepiece 411 of a view finder, from which the object entering the view finder emerges, a standardized connection terminal 412 to be connected to an external computer or the like for data exchange, a contact protective cover 423, and an image pickup module 211 positioned in the camera. The camera main body 501 may be formed in a dimension same as that of a PC card, for mounting on a personal computer. In such case, the dimension of the camera is composed of a length of 85.6 mm, a width of 54.0 mm and a thickness of 3.3 mm (PC card standard type 1) or 5.0 mm (PC card standard type 2). The present embodiment merely shows an example of the digital color camera and the function thereof is not limited to the present embodiment.

Referring to Fig. 55, there are shown a casing 414 for holding various components of the camera, a rear cover 415, an image pickup module 211, a switch 416 to be turned on when the release button is depressed, and a protective glass 420. The protective glass 420 bears a coating for increasing the transmittance, in order to prevent ghost image generation. Also in order to minimize the light entering the image pickup module 211 from outside the image taking area, there is provided a light shielding cover 421 in the area other than the effective range. The switch 416 is provided with a first step circuit to be closed when the release button 406 is half depressed and a second step circuit to be closed when it is fully depressed.

First and second prisms 418, 419 constituting a finder optical system are composed of a transparent material such as acrylic resin and have a same refractive index. The interior of the prisms is filled in order that the light can proceed linearly, and the function of the view finder is achieved by the total reflection of the light occurring at the air gap between the first and second prisms.

Also between the protective glass 420 and the image pickup module 211, a light shielding plate 422 is fixed to the casing 414 in order to avoid generation of stray light through a transparent area around the light shielding diaphragm layer 506 in the image pickup module 211.

The light shielding plate 422 is provided, as in the light shielding plate 224 in the embodiment 7, with apertures for introducing the object light into the lenses 801, 802, 803, 804 and avoids entry of other light. Therefore, such digital color camera can obtain an extremely sharp image without stray light.

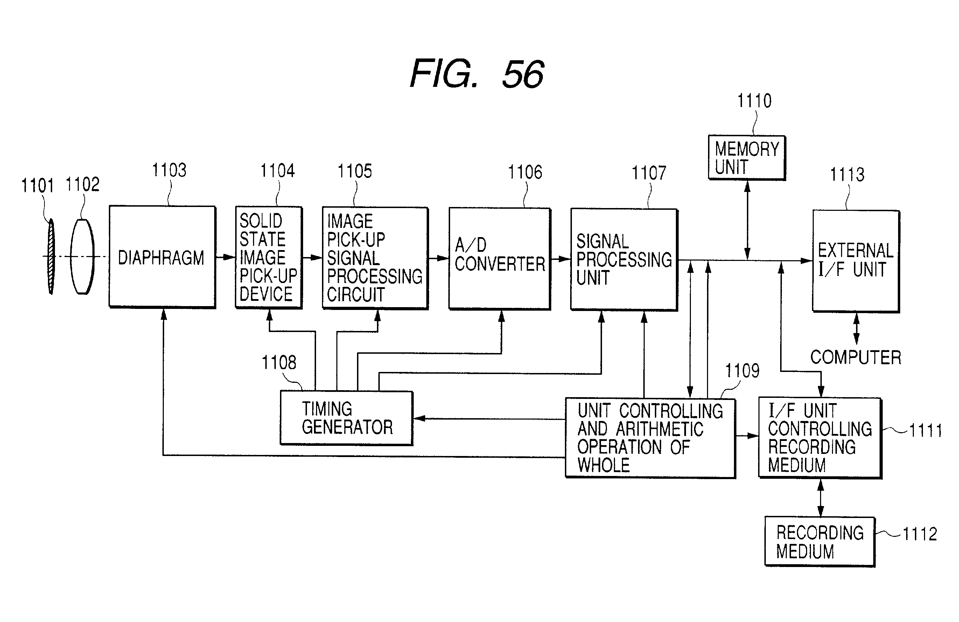

In the following there will be explained an example of application of the image pickup module of the foregoing embodiments to a still camera, with reference to Fig. 56, which is a block diagram showing a case where the image pickup module of the present invention is applied to a "still video camera".

Referring to Fig. 56, there are shown a barrier 1101 serving for lens protection and as a main switch, a lens 1102 for focusing an optical image of the object on a solid-state image pickup element 1104, a diaphragm 1103 for limiting the amount of light passing through the lens 1102, and a solid-state image pickup element 1104 for fetching the image formed by the lens 1102 as an image signal. The lens 1102, the diaphragm 1103 and the solid-state image pickup element 1104 constitute an image pickup module. There are also provided an A/D converter 1106 for analog-digital conversion of the image signal outputted from the solid-state image pickup element 1104, a signal processing unit 1107 for executing various corrections and data compression on the image data outputted from the A/D converter 1106, a timing generator 1108 for supplying the solid-state image pickup element 1104, image signal processing unit 1105, A/D converter 1106 and signal processing unit 1107 with various timing signals, an entire control/operation unit 1109 for controlling various operations and the entire still video camera, a memory unit 1110 for temporarily storing the image data, an interface unit 1111 for recording on or reading from a recording medium, a detachable recording medium 1112 such as a semiconductor memory for recording or readout of image data, and an interface unit 1113 for communication with an external computer or the like.

In the following there will be explained the function of the still video camera of the above-described configuration in the image pickup operation.

When the barrier is opened, there is at first turned on a main power supply, then turned on is a controlling power supply and a power supply is then turned on for the image pickup circuits including the A/D converter etc.

Then, for controlling the exposure amount, the entire control/operation unit 1109 controls the charge accumulation time of the solid-state image pickup element 1104. The signal from the solid-state image pickup element 1104 is converted by the A/D converter 1106 and is supplied to the signal processing unit 1107. Based on such data, the entire control/operation unit 1109 calculates the exposure.

The brightness is judged from the result of such light metering, and the entire control/operation unit 1109 again controls the charge accumulation time accordingly.

The main exposure is started after the appropriate exposure amount is confirmed. After the exposure, the image signal outputted from the solid-state image pickup element 1104 is A/D converted in the A/D converter 1106, then is processed in the signal processing unit 1107 and is written into the memory unit by the entire control/operation unit 1109. Then the data accumulated in the memory unit 1110 are recorded, under the control of the entire control/operation unit 1109, through the recording medium control I/F unit and in the detachable recording medium 1112 such as a semiconductor memory. Such data may also be entered, through the external I/F unit 1113, directly into a computer or the like for image processing. The camera may also be so constructed as to record a moving image.

The invention provides an image pickup module comprising a semiconductor chip including a photosensor array, and an optical element for guiding light to the photosensor array, wherein the optical element includes a imaging unit and a light shielding layer, and adhesive is formed in a position between the semiconductor chip and the optical element but excluding the position of the light shielding layer in the incident direction of light, and the optical element and the semiconductor chip are fixed across the adhesive. The invention also provides an image pickup module comprising an optical element provided on a semiconductor chip, wherein the optical element includes a first lens and a second lens which is provided corresponding to the first lens.

## Claims

1. An image pickup module comprising a semiconductor chip including a photosensor array and an optical element for guiding light to said photosensor array, wherein said optical element includes a imaging unit, a light shielding layer, and adhesive formed in a position between said semiconductor chip and said optical element but excluding said light shielding layer in the incident direction of light, and said optical element and said semiconductor chip are fixed through said adhesive.

2. An image pickup module according to claim 1, wherein said adhesive is seal-shaped adhesive or ultraviolet hardening resin.

3. An image pickup module according to claim 1, wherein the adhesive formed on said semiconductor chip is provided, in a part of said adhesive, with an aperture for dissipating the pressure inside said adhesive.

4. An image pickup module according to claim 1, wherein a spacer is mixed in said adhesive to form a predetermined gap between said semiconductor chip and said optical element.

5. An image pickup module according to claim 1, further comprising a light shielding plate for preventing light entry.

6. An image pickup module according to claim 1, wherein said optical element and said semiconductor chip are adhered with mutual displacement in one direction or two directions, and an electrode pad for electrical connection with the exterior is formed in an upward open position of said semiconductor chip.

7. An image pickup module according to claim 1, wherein said optical element is composed of an upper substrate including said imaging unit and a lower substrate including said light shielding plate.

8. An image pickup module according to claim 1, wherein said optical element is stereoscopic optical element including plural imaging units.

9. An image pickup module according to claim 1, wherein said optical element includes a color filter or an infrared cut-off filter.

10. A digital camera comprising an image pickup module according to claim 1.

11. A method for producing an image pickup module provided with a semiconductor chip including a photosensor array and an optical element including an imaging unit and a light shielding layer, the method comprising a step of adhering an optical element assembly and a semiconductor wafer bearing plural photosensor arrays with adhesive formed in a position excluding said light shielding layer with respect to the incident direction of light, a step of hardening said adhesive, and a dicing step in a position other than said imaging unit.

12. A method for producing an image pickup module according to claim 11, wherein the step of adhering said optical element assembly and said semiconductor wafer with the adhesive includes a step adhering a lower substrate assembly constituting said optical element assembly and said semiconductor wafer with said adhesive, and a step of then adjoining an upper substrate assembly constituting said optical element and said lower substrate assembly.

13. A method for producing an image pickup module according to claim 11, wherein said dicing step is a step of dicing along an area excluding said adhesive, or an area where a surfacial resin portion on said optical element is formed thinner than in other portions, or a groove formed on the surface of said optical element.

14. An image pickup module comprising an optical element provided on a semiconductor chip, wherein said optical element includes a first lens and a second lens, and said second lens is provided corresponding to said first lens.

15. An image pickup module according to claim 14, wherein said second lens is a distributed refractive index lens.

16. An image pickup module according to claim 14, wherein said optical element is constituted by adjoining an upper substrate and a lower substrate, and said first lens is formed in said upper substrate while said second lens is formed in said lower substrate.

17. An image pickup module according to claim 14, wherein said first lens and said second lens are adjusted coaxially.

18. An image pickup module according to claim 14, wherein said optical element is a stereoscopic optical element including a first stereoscopic lens formed by plural said first lenses and a second stereoscopic lens formed by plural said second lenses.

19. An image pickup module according to claim 14, wherein said optical element includes a color filter or an infrared cut-off filter.

20. An image pickup module according to claim 14, wherein said optical element includes a light shielding diaphragm layer provided with an aperture corresponding to said first lens or said second lens, and said light shielding diaphragm layer is positioned between said first lens and said second lens.

21. An image pickup module according to claim 14, wherein said semiconductor chip includes a microlens thereon.

22. A digital camera comprising an image pickup module according to claim 14.

23. An image pickup module comprising a semiconductor chip including a photosensor array and an optical element for guiding light to said photosensor array, wherein said optical element includes a first lens and a second lens corresponding to said first lens, said module further comprises adhesive formed between said semiconductor chip and said optical element and excluding a light shielding layer, and said optical element and said semiconductor chip are fixed through said adhesive.

24. An image pickup module according to claim 23, wherein said second lens is a distributed refractive index lens.

25. An image pickup module according to claim 23, wherein said optical element is a stereoscopic optical element including four first stereoscopic lenses and second stereoscopic lenses respectively corresponding to said first stereoscopic lenses.

26. A digital camera comprising an image pickup module according to claim 22.
